# EUROPEAN PATENT SPECIFICATION

(11) **EP 2 354 852 B1**
(45) Date of publication and mention of the grant of the patent: **10.05.2017**
(21) Application number: 11152668.7
(22) Date of filing: 31.01.2011
(51) Int. Cl.: G03F 7/11, G03F 7/16, G03F 7/033, G03F 7/32

(54) **Method of preparing lithographic printing plate**
Verfahren zur Herstellung einer Lithographiedruckplatte
Procédé pour la préparation d'une plaque d'impression lithographique

(30) Priority: 29.01.2010 JP 2010019675
(43) Date of publication of application: 10.08.2011
(73) Proprietor: Fujifilm Corporation, Minato-ku Tokyo 106-0031 (JP)
(72) Inventor: Ishiguro, Yuriko, Shizuoka (JP); Arimura, Keisuke, Shizuoka (JP)
(74) Representative: Hoffmann Eitle

(56) References cited:
- EP-A1- 1 715 386
- EP-A1- 1 788 434
- EP-A1- 1 865 382
- EP-A1- 2 090 933
- EP-A1- 2 103 994
- EP-A1- 2 105 797
- EP-A2- 1 075 941
- EP-A2- 1 491 356
- US-A1- 2003 068 575

## Description

### FIELD OF THE INVENTION

The present invention relates to a lithographic printing plate precursor and a method of preparing a lithographic printing plate, in particular, to a lithographic printing plate precursor capable of providing a lithographic printing plate excellent in a fingerprint trace stain preventing property and a method of preparing a lithographic printing plate using the same.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

In recent years, digitalized technique of electronically processing, accumulating and outputting image information using a computer has been popularized, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

Further, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous strong alkali solution having pH of more than 11, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a developing method of processing with a developer having pH of 8.5 to 11.5 and a dielectric constant of 3 to 30 mS/cm and containing an alkali metal carbonate and an alkali metal hydrogen carbonate is proposed in JP-A-11-65126 (the term "JP-A" as used herein means an "unexamined published Japanese patent application"). However, since the developing method is required a water-washing step and a treatment step with a gum solution, it does not resolve the problems of the environment and running cost.

Also, a processing with a processing solution having pH of 11.9 to 12.1 and containing a water-soluble polymer compound is described in the example of EP-A-1868036. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to result in deterioration in printing durability or ink-receptive property. In JP-T-2007-538279 (the term "JP-T" as used herein means a published Japanese translation of a PCT patent application), a processing with a processing solution having pH of 3 to 9 and containing a water-soluble polymer compound is described. However, since the processing solution does not contain a basic component, it is necessary to enable development by making a polymer used in the photosensitive layer hydrophilic and thus, a problem occurs in that printing durability severely degrades. In WO 2007/144096, a processing method wherein development processing is conducted using an alkali solution having pH of 9.5 to 14 and after that a gum treatment step is not carried out is described. However, the method has a problem of tackiness of a surface of printing plate after development.

Moreover, since the treatment step with a gum solution is not conducted in the processing methods of EP-A-1868036, JP-T-2007-538279 and WO 2007/144096, surface protection function is poor. Specifically, the non-image area of printing plate is apt to be stained due to external factors and particularly, there is a problem in that printing stain (hereinafter, also referred to as fingerprint trace stain) occurs when the non-image area of printing plate after development is held with one's bare hand.

### SUMMARY OF THE INVENTION

Therefore, an object of the present invention is to provide a method of preparing a lithographic printing plate each of which overcomes the problems of the prior art. More specifically, it is to provide a lithographic printing plate precursor and a method of preparing a lithographic printing plate each of which can prevent occurrence of fingerprint trace stain and is capable of conducting one solution processing. The term "one solution processing" as used herein means processing in which development processing and gumming treatment both of which are minimally required in a standard processing are simultaneously conducted with one solution.

As a result of the intensive investigations, the inventor has found that the above-described object can be achieved by a method of preparing a lithographic printing plate according to the constructions described below to complete the present invention.

The present invention provides a method of preparing a lithographic printing plate comprising developing the lithographic printing plate precursor as described in claim 1 with embodiments thereof in claims 2 and 3.

According to the present invention, the claimed method of preparing a lithographic printing plate can prevent occurrence of fingerprint trace stain and is capable of conducting one solution processing can be provided.

Further, since the one solution processing with a weak alkaline processing solution can be conducted, advantages, for example, high safety, simplification of processing step, consideration for global environment, and adaptation for space saving and low running cost are achieved.

### BRIEF DESCRIPTION OF THE DRAWINGS

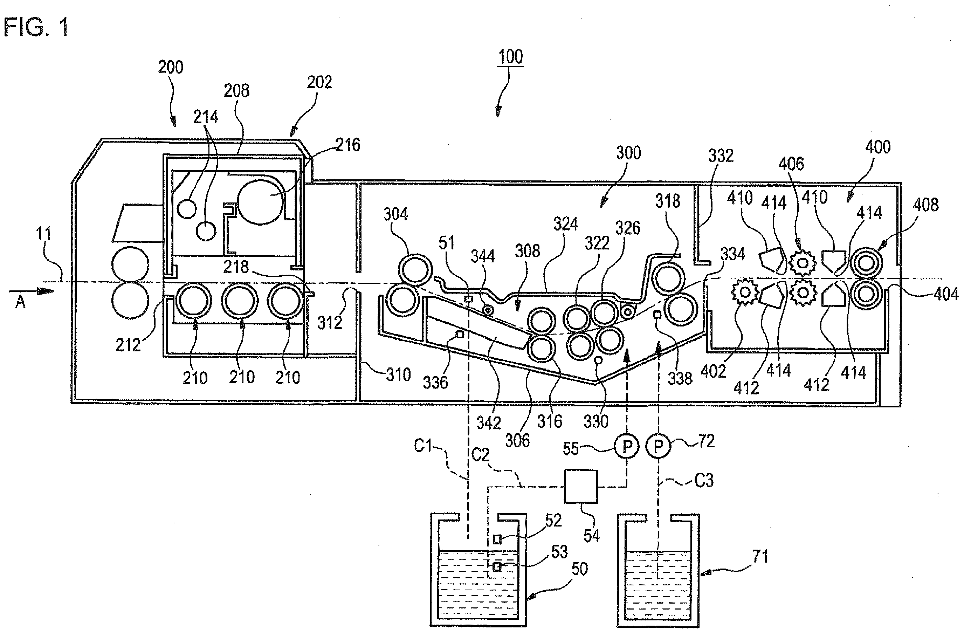

Fig. 1 is an illustration showing a structure of an automatic development processor.

### [Description of reference numerals and signs]

- 11:: Transporting path
- 100:: Automatic development processor
- 200:: Pre-heating unit
- 300:: Developing unit
- 400:: Drying unit
- 202:: Machine casing
- 208:: Heating chamber
- 210:: Skewer roller
- 212:: Transporting inlet
- 214:: Heater
- 216:: Circulation fan
- 218:: Transporting outlet
- 304:: Insertion roller pair
- 306:: Processing tank
- 308:: Developing tank
- 310:: Outer panel
- 312:: Slit type insertion slot
- 316:: Submerged roller pair
- 318:: Carrying-out roller pair
- 322:: Brush roller pair
- 324:: Shielding cover
- 326:: Brush roller pair
- 330:: Spray pipe
- 334:: Slit type path-through slot
- 336:: Liquid temperature sensor
- 338:: Liquid level meter
- 332:: Partition board
- 342:: Guide member
- 344:: Guide roller
- 402:: Support roller
- 404:: Discharge slot
- 406:: Transport roller pair
- 408:: Transport roller pair
- 410,412:: Duct
- 414:: Slit hole
- 50:: External tank
- 51:: Overflow aperture
- 52:: Upper limit liquid level meter
- 53:: Lower limit liquid level meter
- 54:: Filter unit
- 55:: Developer supply pump
- C1:: First circulation pipeline
- C2:: Second circulation pipeline
- 71:: Water tank for replenishment
- 72:: Water-replenishing pump
- C3:: Third circulation pipeline

### DETAILED DESCRIPTION OF THE INVENTION

### [Lithographic printing plate precursor]

The lithographic printing plate precursor used in the method of the invention will be described in detail below.

The lithographic printing plate comprises a support and an image-recording layer containing (A) a sensitizing dye, (B) a polymerization initiator, (C) a polymerizable compound and (D) a binder polymer, these compounds being as claimed in claim 1.

The lithographic printing plate precursor according to the invention can provide a lithographic printing plate which does not cause printing stain or hardly causes printing stain even when a fingerprint is attached. The reason for this is believed to be that in the case where the lithographic printing plate precursor is subjected to one solution processing, a hydroxycarboxylate ion can remain on the surface of support of the lithographic printing plate after processing and the remaining hydroxycarboxylate ion is attached to the surface of support so that attachment of the oily component contained in the fingerprint to the surface of support can be prevented. Such a preventing effect becomes greater when a total number of the hydroxy group and carboxylic acid group included in the hydroxycarboxylate salt is 3 or more.

### [Hydroxycarboxylate salt]

The hydroxycarboxylate salt for use in the lithographic printing plate precursor is described below. The hydroxycarboxylate salt is a salt of hydroxycarboxylic acid.

The hydroxycarboxylic acid indicates a collective term of organic compounds having a carboxyl group and an alcoholic hydroxy group in their molecules and is also called a hydroxy acid, an oxy acid, an oxycarboxylic acid or an alcohol acid according to Iwanami Rikagaku Jiten (Iwanami Physical and Chemical Dictianary), 4th Edition.

The hydroxycarboxylate salt for use in the invention preferably includes a compound represented by formula (I) shown below.

R(OH)ₘ(COOM)ₙ (I)

In formula (I), R represents an (m + n) valent organic group, M represents an alkali metal or an onium, m and n each represents an integer of 1 or more, and when n is 2 or more, Ms may be the same or different.

In formula (I), the (m + n) valent organic group represented by R includes, for example, an (m + n) valent hydrocarbon group. The hydrocarbon group may have a substituent and/or a connecting group. The hydrocarbon group includes, for example, an (m + n) valent group derived from an aliphatic hydrocarbon, for example, an alkylene group, an alkanetriyl group, an alkanetetrayl group, an alkanepentayl group, an alkenylene group, an alkenetriyl group, an alkenetetrayl group, an alkenepentayl group, an alkynylene group, an alkynetriyl group, an alkynetetrayl group or an alkynepentayl group, and an (m + n) valent group derived from an aromatic hydrocarbon, for example, an arylene group, an arenetriyl group, an arenetetrayl group or an arenepentayl group. Examples of the substituent other than the hydroxy group and carboxyl group include an alkyl group, an alkenyl group, an alkynyl group, an aralkyl group and an aryl group. Specific examples of the substituent include, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbomyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group and a phenoxycarbonylphenyl group. The connecting group is constructed from a hydrogen atom, a carbon atom, an oxygen atom, a nitrogen atom, a sulfur atom and a halogen atom and preferably contains from 1 to 50 atoms. Specific examples of the connecting group include an alkylene group, a substituted alkylene group, an arylene group and a substituted arylene group. The connecting group may have a structure wherein a plurality of such divalent groups is connected to each other through any of an amido bond, an ether bond, a urethane bond, a urea bond and an ester bond.

The alkali metal represented by M includes, for example, lithium, sodium and potassium and is particularly preferably sodium. The onium includes, for example, ammonium, phosphonium and sulfonium and is particularly preferably ammonium.

The total number of m and n is preferably 3 or more and the upper limit thereof is suitably about 10. The total number of m and n is more preferably from 3 to 8, and still more preferably from 4 to 6.

The hydroxycarboxylate salt for use in the invention preferably has a molecular weight of 600 or less. In case of the hydroxycarboxylate salt having a molecular weight exceeding 600, the fingerprint trace stain preventing effect may decrease. The molecular weight of the hydroxycarboxylate salt is more preferably 500 or less, and particularly preferably 300 or less.

The hydroxycarboxylic acid constituting the hydroxycarboxylate salt specifically includes, for example, gluconic acid, glycolic acid, lactic acid, tartronic acid, a hydroxybutyric acid (for example, 2-hydroxybutyric acid, 3-hydroxybutyric acid or γ-hydroxybutyric acid), malic acid, tartaric acid, citramalic acid, citric acid, isocitric acid, leucic acid, mevalonic acid, pantoic acid, ricinoleic acid, ricinelaidic acid, cerebronic acid, quinic acid, shikimic acid, a monohydroxybenzoic acid derivative (for example, salicylic acid, creosotic acid (also referred to as homosalicylic acid or hydroxyl(methyl)benzoic acid), vanillic acid or syringic acid), a dihydroxybenzoic acid derivative (for example, pyrocatechuic acid, resorcylic acid, protocatechuic acid, gentistic acid or orsellinic acid), a trihydroxybenzoic acid derivative (for example, gallic acid), a phenylacetic acid derivative (for example, mandelic acid, benzilic acid or atrolactic acid), a hydrocinnamic acid derivative (for example, melilotic acid, phloretic acid, coumaric acid, umbellic acid, caffeic acid, ferulic acid or sinapic acid), celebronic acid and carminic acid. Of the compounds, as hydroxycarboxylic acid having one carboxylic acid group and two or more hydroxy groups, gluconic acid or shikimic acid is preferred, as hydroxycarboxylic acid having two or more carboxylic acid groups and one hydroxy group, citric acid or malic acid is preferred, and as hydroxycarboxylic acid having two or more carboxylic acid groups and two or more hydroxy groups, tartaric acid is preferred. Among them, gluconic acid, citric acid, tartaric acid or malic acid is particularly preferred.

The hydroxycarboxylate salts may be used individually or in combination of two or more thereof. The hydroxycarboxylate salt used in the invention is characterized by having both a hydroxy group and a carboxylic group and a compound having only one of these functional groups does not exhibit the fingerprint trace satin preventing effect.

According to the invention, the hydroxycarboxylate salt is incorporated into the intermediate layer.

### [Support]

A support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the surface treatments, methods described in Paragraph Nos. [0241] to [0245] of JP-2007-206217 are preferably used.

The center line average roughness of the support is preferably from 0.10 to 1.2 µm. In the range described above, good adhesion property to the layer contacting with the support and good printing durability and good resistance to stain in a printing plate are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### <Hydrophilizing treatment of support>

In the lithographic printing plate precursor according to the invention, in order to increase hydrophilicity of the non-image area and to prevent printing stain it is preferred to conduct hydrophilizing treatment of the surface of support. The hydrophilizing treatment of the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid.

### [Intermediate layer]

In the lithographic printing plate precursor according to the invention, an intermediate layer is provided between the image-recording layer and the support. The intermediate layer may contain a polymer compound.

The polymer compound for use in the intermediate layer preferably has a functional group capable of interacting with the surface of support. As the functional group capable of interacting with the surface of support, a group capable of undergoing formation of a bond, for example, a covalent bond, an ionic bond or a hydrogen bond or undergoing interaction, for example, polar interaction, with metal, a metal oxide, a hydroxy group or the like present on the support is exemplified. Among them, a functional group (an adsorbing group to surface of support) adsorbing to the surface of support is preferred.

Whether the adsorptivity to the surface of support is present or not can be judged, for example, by the following method.

Specifically, a test compound is dissolved in a solvent in which the test compound is easily soluble to prepare a coating solution, and the coating solution is coated and dried on a support so as to have the coating amount after drying of 30 mg/m². After thoroughly washing the support coated with the test compound using the solvent in which the test compound is easily soluble, the residual amount of the test compound that has not been removed by the washing is measured to calculate the adsorption amount of the test compound to the support. For measurement of the residual amount, the amount of the residual test compound may be directly determined, or it may be calculated from the amount of the test compound dissolved in the washing solution. The determination for the compound can be performed, for example, by fluorescent X-ray measurement, reflection spectral absorbance measurement or liquid chromatography measurement. The compound having the adsorptivity to support means a compound that remains by 0.1 mg/m² or more even after conducting the washing treatment described above.

The adsorbing group to surface of support is a functional group capable of forming a chemical bond (for example, an ionic bond, a hydrogen bond, a coordinate bond or a bond with intermolecular force) with a substance (for example, metal or a metal oxide) or a functional group (for example, a hydroxy group) present on the surface of support. The adsorbing group is preferably an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OPO₃H₂, -BO₃H₂, -CONHSO₂- -SO₂NHSO₂- and -COCH₂COCH₃. Among them, -OPO₃H₂ or -PO₃H₂ is particularly preferred. The acid group may be the form of a metal salt.

The cationic group is preferably an onium group. Examples of the onium group include an ammonium group (including a cyclic ammonium group, for example, a pyridinium group), a phosphonium group, an arsonium group, a stibonium group, an oxonium group, a sulfonium group, a selenonium group, a stannonium group and iodonium group. Among them, an ammonium group, a phosphonium group or a sulfonium group is preferred, an ammonium group or a phosphonium group is more preferred, and an ammonium group is particularly preferred.

A phosphoric ester group (including a salt thereof) or a β-diketone group (for example, an acetylacetone group) is also preferred as the adsorbing group to surface of support.

Preferable examples of the adsorbing group to surface of support are set forth below.

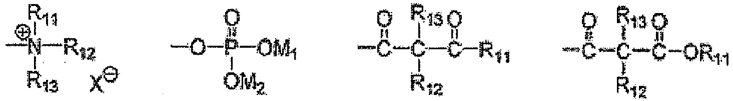

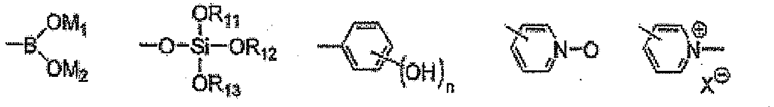

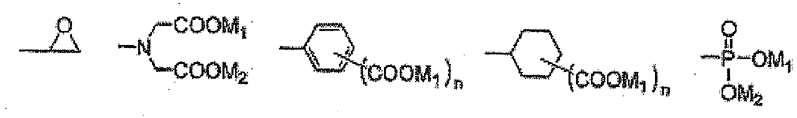

In the above-formulae, R₁₁ to R₁₃ each independently represents a hydrogen atom, an alkyl group, an aryl group, an alkynyl group or an alkenyl group. M₁ and M₂ each independently represents a hydrogen atom, a metal atom or an ammonium group. X⁻ represents a counter anion n represents an integer from 1 to 5.

As the adsorbing group to surface of support, an onium group, a phosphoric ester group or a salt thereof, a phosphonic acid group or a salt thereof, a boric acid group or a salt thereof or a β-diketone group is particularly preferred. The phosphoric ester group or phosphonic acid group is most preferred.

Introduction of the functional group capable of interacting with the surface of support into the polymer compound for intermediate layer can be easily carried out, for example, by polymerization using a monomer having the functional group capable of interacting with the surface of support. A repeating unit corresponding to the monomer having the functional group capable of interacting with the surface of support is represented, for example, by formula (A1) shown below.

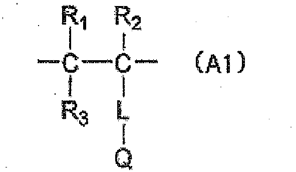

In formula (A1), R₁ to R₃ each independently represents a hydrogen atom, an alkyl group having from 1 to 6 carbon atoms or a halogen atom. L represents a single bond or a divalent connecting group selected from the group consisting of -CO-, -O-, -NH-, a divalent aliphatic group, a divalent aromatic group and a combination thereof. Q represents a functional group capable of interacting with the surface of support.

The functional group capable of interacting with the surface of support is same as that described above.

Specific examples of the divalent connecting group composed of the combination of groups represented by L are set forth below. In each of the specific examples shown below, the left side connects to the main chain.
L1: -CO-NH-divalent aliphatic group-O-CO-
L2: -CO-divalent aliphatic group-O-CO-
L3: -CO-O-divalent aliphatic group-O-CO-
L4: -divalent aliphatic group-O-CO-
L5: -CO-NH-divalent aromatic group-O-CO-
L6: -CO-divalent aromatic group-O-CO-
L7: -divalent aromatic group-O-CO-
L8: -CO-O-divalent aliphatic group-CO-O-divalent aliphatic group-O-CO-
L9: -CO-O-divalent aliphatic group-O-CO-divalent aliphatic group-O-CO-
L10: -CO-O-divalent aromatic group-CO-O-divalent aliphatic group-O-CO-
L11: -CO-O-divalent aromatic group-O-CO-divalent aliphatic group-O-CO-
L12: -CO-O-divalent aliphatic group-CO-O-divalent aromatic group-O-CO-
L13: -CO-O-divalent aliphatic group-O-CO-divalent aromatic group-O-CO-
L14: -CO-O-divalent aromatic group-CO-O-divalent aromatic group-O-CO-
L15: -CO-O-divalent aromatic group-O-CO-divalent aromatic group-O-CO-
L16: -CO-O-divalent aromatic group-O-CO-NH-divalent aliphatic group-O-CO-
L17: -CO-O-divalent aliphatic group-O-CO-NH-divalent aliphatic group-O-CO-
L18: -CO-NH-
L19: -CO-O-

The divalent aliphatic group includes an alkylene group, a substituted alkylene group, an alkenylene group, a substituted alkenylene group, an alkinylene group, a substituted alkinylene group and a polyalkyleneoxy group. Among them, an alkylene group, a substituted alkylene group, an alkenylene group or a substituted alkenylene group is preferred, and an alkylene group or a substituted alkylene group is more preferred. Of the divalent aliphatic groups, a chain structure is more preferable than a cyclic structure, and further a straight chain structure is more preferable than a branched chain structure. A number of carbon atoms included in the divalent aliphatic group is preferably from 1 to 20, more preferably from 1 to 15, still more preferably from 1 to 12, yet still more preferably from 1 to 10, and particularly preferably from 1 to 8.

Examples of the substituent for the divalent aliphatic group include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group and a diarylamino group.

The divalent aromatic group includes an arylene group and a substituted arylene group. It preferably includes a phenylene group, a substituted phenylene group, a naphthylene group and a substituted naphthylene group.

Examples of the substituent for the divalent aromatic group include an alkyl group in addition to the substituents described for the divalent aliphatic group above.

Particularly preferable examples of the monomer having a functional group capable of interacting with the surface of support include compounds represented by formula (VII) or (VIII) shown below.

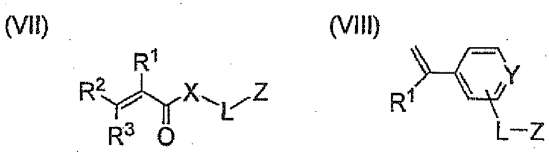

In formula (VII) or (VIII), R¹, R² and R³ each independently represents a hydrogen atom, halogen atom or an alkyl group having from 1 to 6 carbon atoms. R¹, R² and R³ each independently represents preferably a hydrogen atom or an alkyl group having from 1 to 6 carbon atoms, more preferably a hydrogen atom or an alkyl group having from 1 to 3 carbon atoms, and particularly preferably a hydrogen atom or a methyl group. R² and R³ are particularly preferably hydrogen atoms, respectively.

In formula (VII), X represents an oxygen atom (-O-) or imino group (-NH-). X is preferably an oxygen atom.

In the formula (VII) or (VIII), L represents a divalent connecting group. L is preferably a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of each of the groups described above with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may form a cyclic structure or a branched structure. A number of carbon atoms of the aliphatic group is preferably from 1 to 20, more preferably from 1 to 15, and particularly preferably from 1 to 10. Of the aliphatic groups a saturated aliphatic group is more preferable than an unsaturated aliphatic group. The aliphatic group may have a substituent. Examples of the substituent include a halogen atom, a hydroxy group, an aromatic group and a heterocyclic group.

A number of carbon atoms of the aromatic group is preferably from 6 to 20, more preferably from 6 to 15, and particularly preferably from 6 to 10. The aromatic group may have a substituent. Examples of the substituent include a halogen atom, a hydroxy group, an aliphatic group, an aromatic group and a heterocyclic group.

The heterocyclic group preferably has a 5-membered or 6-membered ring as the hetero ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thioxo group (=S), an imino group (=NH), a substituted imino group (=N-R, wherein R represents an aliphatic group, an aromatic group or a heterocyclic group), an aliphatic group, an aromatic group and a heterocyclic group.

L is preferably a divalent connecting group containing a plurality of polyoxyalkylene structures. The polyoxyalkylene structure is more preferably a polyoxyethylene structure. Specifically, L preferably contains -(OCH₂CH₂)ₙ- (wherein n is an integer of 2 or more).

In formula (VII) or (VIII), Z represents an adsorbing group to surface of support. The adsorbing group to surface of support is same as that described above.

In formula (VIII), Y represents a carbon atom or a nitrogen atom. In the case where Y is a nitrogen atom and L is connected to Y to form a quaternary pyridinium group, Z is not mandatory, because the quaternary pyridinium group itself exhibits the adsorptivity.

Representative examples of the monomer represented by formula (VII) or (VIII) are set forth below.

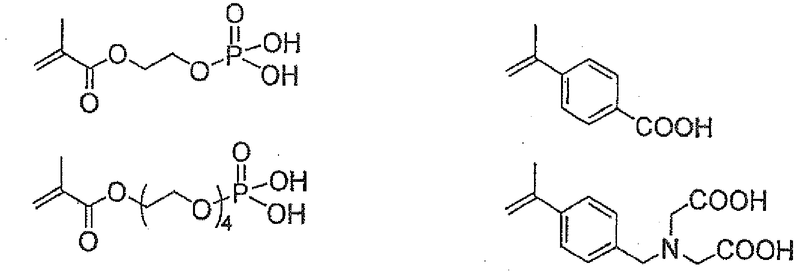

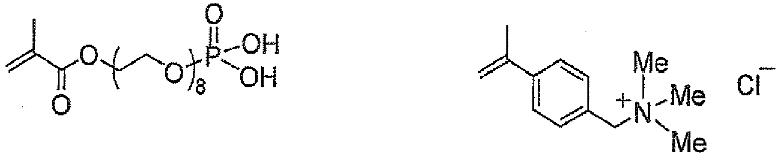

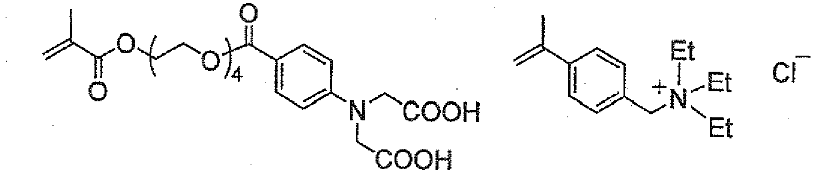

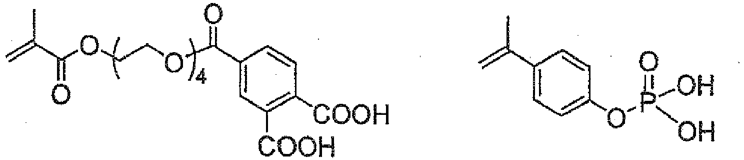

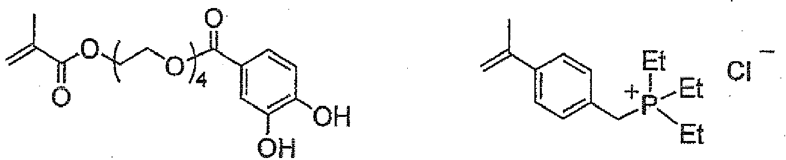

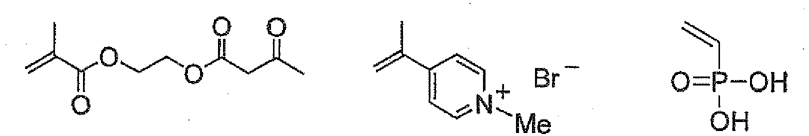

The polymer compound for intermediate layer may contain only one kind or two or more kinds of the monomer unit having the functional group capable of interacting with the surface of support.

The content of the monomer unit having the functional group capable of interacting with the surface of support in the polymer compound for intermediate layer is preferably from 2 to 80% by mole, more preferably from 2 to 70% by mole, still more preferably from 5 to 50% by mole, particularly preferably from 10 to 40% by mole, based on the total monomer unit of the polymer compound.

The polymer compound for intermediate layer preferably further has a hydrophilic group. The hydrophilic group preferably includes, for example, a hydroxy group, a carboxyl group, a carboxylate group, a hydroxyethyl group, a hydroxypropyl group, a polyoxyalkylene group, for example, a polyoxyethylene group or a polyoxypropylene group, an amino group, an aminoethyl group, an aminopropyl group, an ammonium group, an amido group, a carboxymethyl group, a sulfonic acid group or a salt thereof and a group having a betain structure.

The more preferable hydrophilic group includes a sulfonic acid group (-SO₃H) or a salt thereof (-SO₃M, wherein M represents a counter cation other than a proton (H⁺)), an amido group (-CONR-, wherein R represents a hydrogen atom or an organic group), a polyalkyleneoxy group and a group having a betain structure.

The betain structure is a structure having both a cation structure and an anion structure and an electric charge is neutralized therein. The cation structure in the betain structure is not particularly restricted and is preferably a quaternary nitrogen cation. The anion structure in the betain structure is not particularly restricted and is preferably -COO⁻, -SO₃⁻, -PO₃²⁻ or -PO₃H⁻, and more preferably -COO⁻ or -SO₃⁻.

The still more preferable hydrophilic group is a sulfonic acid group or a salt thereof or a group having a betain structure.

Introduction of the hydrophilic group into the polymer compound for intermediate layer can be easily carried out, for example, by polymerization using a monomer having the hydrophilic group. A repeating unit corresponding to the monomer having the hydrophilic group is represented, for example, by formula (A2) shown below.

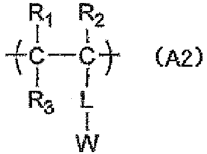

In formula (A2), R₁ to R₃ and L have the same meanings as R₁ to R₃ and L defined in formula (A1), respectively. W represents a group shown below.

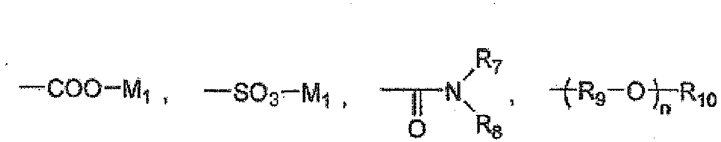

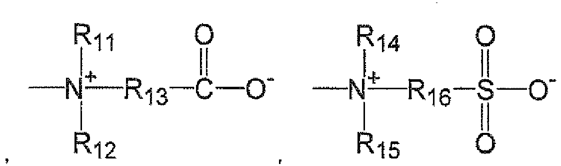

In the formulae, M₁ has the same meaning as M₁ defined with respect to the adsorbing group to surface of support described above. R₇, R₈, R₁₁, R₁₂, R₁₄ and R₁₅ each independently represents a hydrogen atom or a straight chin or branched alkyl group having from 1 to 6 carbon atoms. R₉ represents a straight chin or branched alkylene group having from 1 to 6 carbon atoms, and preferably an ethylene group. R₁₀ represents a hydrogen atom or an alkyl group having from 1 to 12 carbon atoms. n represents an integer from 1 to 100, and preferably an integer from 1 to 30. R₁₃ and R₁₆ each independently represents a divalent organic group, for example, a divalent connecting group selected from the group consisting of a divalent aliphatic group, a divalent aromatic group and a combination of these groups.

Specific examples of the repeating unit corresponding to the monomer having a hydrophilic group are set forth below.

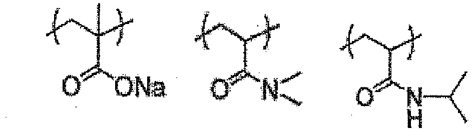

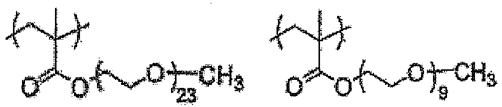

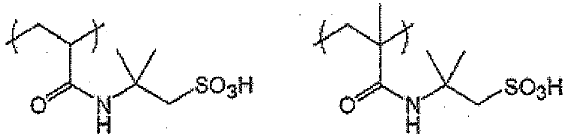

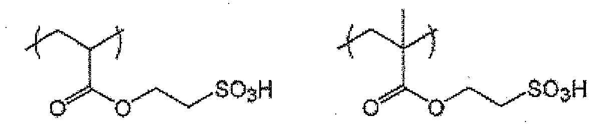

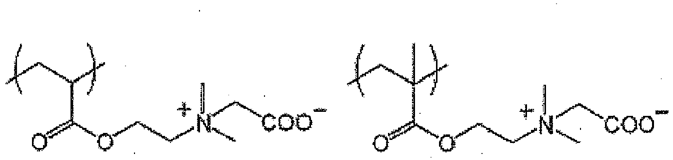

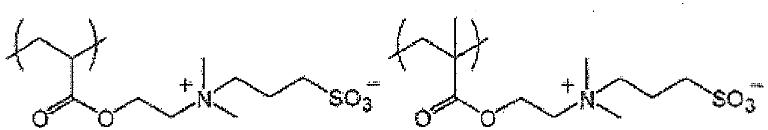

The repeating unit having a hydrophilic group represented by formula (A2) preferably has log P from -3 to 3, and more preferably from -1 to 2. In the range described above, the stain preventing property in the non-image area is more preferably achieved.

The term "log P" as used herein means a logarithm of a value of octanol/water partition coefficient (P) of a compound calculated using software PC Models developed by Medicinal Chemistry Project, Pomona College, Claremont, California and available from Daylight Chemical Information Systems, Inc.

The polymer compound for intermediate layer may contain only one kind or two or more kinds of the monomer unit having a hydrophilic group.

The content of the monomer unit having a hydrophilic group in the polymer compound for intermediate layer is preferably from 30 to 98% by mole, more preferably from 40 to 90% by mole, and still more preferably from 50 to 90% by mole, based on the total monomer unit of the polymer compound.

In the polymer compound for intermediate layer, the functional group capable of interacting with the surface of support contained in the monomer unit having the functional group capable of interacting with the surface of support is preferably different from the hydrophilic group contained in the monomer unit having a hydrophilic group.

The polymer compound for intermediate layer preferably further has a crosslinkable group. Introduction of the crosslinkable group into the polymer compound for intermediate layer can be easily carried out, for example, by polymerization using a monomer having the crosslinkable group. Also, it can be conducted by introducing the crosslinkable group, for example, an ethylenically unsaturated bond group into a side chain of the polymer compound or by forming a salt structure between a polar substituent of the polymer compound and a compound having a counter charge to the polar substituent and an ethylenically unsaturated bond group.

A repeating unit corresponding to the monomer having the crosslinkable group is represented, for example, by formula (A3) shown below.

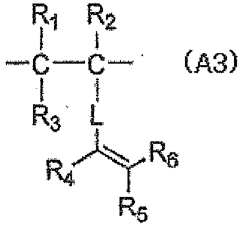

In formula (A3), R₁ to R₃ have the same meanings as R₁ to R₃ defined in formula (A1), respectively. R₄ to R₆ each independently represents a hydrogen atom, an alkyl group having from 1 to 6 carbon atoms, a halogen atom, an acyl group or an acyloxy group. Alternatively, R₄ and R₅ or R₅ and R₆ may be combined with each other to form a ring. L represents a divalent connecting group selected from the group consisting of -CO-, -O-, -NH-, a divalent aliphatic group, a divalent aromatic group and a combination thereof.

Specific examples of the divalent connecting group composed of the combination of groups represented by L include L1 to L19 set forth with respect to formula (A1) above. In each of the specific examples, the left side connects to the main chain and the right side connects to the ethylenically unsaturated bond group.

Of L1 to L19 described above, L1, L3, L5, L7, L17, L18 or L19 is preferred, L1, L3, L5 or L17 is more preferred, and L1 or L17 is particularly preferred.

Preferable examples of the monomer having a crosslinkable group used in the polymer compound for intermediate layer include an ester or amide of acrylic acid or methacrylic acid, which is a monomer wherein the ester or amide residue (R in -COOR or -CONHR) has an ethylenically unsaturated bond group.

Examples of the residue (R described above) having an ethylenically unsaturated bond group include -(CH₂)ₙCR₁=CR₂R₃, -(CH₂O)ₙCH₂CR₁₌CR₂R₃, -(CH₂CH₂O)ₙCH₂CR₁=CR₂R₃, -(CH₂)ₙNH-CO-O-CH₂CR₁=CR₂R₃, -(CH₂)ₙ-O-CO-CR₁=CR₂R₃ and -(CH₂CH₂O)₂-X (wherein R₁ to R₃ each independently represents a hydrogen atom a halogen atom or an alkyl group having from 1 to 20 carbon atoms, an aryl group, alkoxy group or aryloxy group, or R₁ and R₂ or R₁ and R₃ may be combined with each other to form a ring. n represents an integer from 1 to 10. X represents a dicyclopentadienyl residue).

Specific examples of the residue having an ethylenically unsaturated bond group in ester preferably include -CH₂CH=CH₂, -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂NHCOO-CH₂CH=CH₂ and -CH₂CH₂O-X (wherein X represents a dicyclopentadienyl residue).

Specific examples of the residue having an ethylenically unsaturated bond group in amide preferably include -CH₂CH=CH₂, -CH₂CH₂O-Y (wherein Y represents a cyclohexene residue) and -CH₂CH₂OCO-CH=CH₂.

A content of the crosslinkable group (content of the radical polymerizable unsaturated double bond determined by iodine titration) in the polymer compound for intermediate layer is preferably from 0.1 to 10.0 mmol, more preferably from 1.0 to 7.0 mmol, most preferably from 2.0 to 5.5 mmol, based on 1 g of the polymer compound. In the range described above, preferable compatibility between the good sensitivity and good stain resistance and good preservation stability are achieved.

The content of the monomer unit having a crosslinkable group in the polymer compound for intermediate layer is preferably from 5 to 80% by mole, more preferably from 5 to 60% by mole, and particularly preferably from 10 to 50% by mole, based on the total monomer unit of the polymer compound.

A polymer compound having a functional group capable of interacting with the surface of support, for example, phosphonic acid or phosphoric acid and the ethylenically double bond reactive group is described, for example, in JP-A-2-304441.

The polymer compound for intermediate layer particularly preferred includes a polymer compound having a functional group capable of interacting with the surface of support, a hydrophilic group and a crosslinkable group (preferably, an ethylenically unsaturated bond group). Specifically, a polymer compound obtained by copolymerization of a monomer having a functional group capable of interacting with the surface of support, a monomer having a hydrophilic group and a monomer having a crosslinkable group is exemplified.

When the polymer compound for intermediate layer has a functional group capable of interacting with the surface of support, a hydrophilic group and a crosslinkable group, the strong adhesion property between the support and the image-recording layer is generated in the exposed area, and since the polymer compound has the hydrophilic group, high hydrophilicity is obtained in the unexposed area where the image-recording layer has been removed by development Thus, the polymer compound can contribute to the compatibility between printing durability in the exposed area and stain resistance in the unexposed area.

A weight average molecular weight of the polymer compound for intermediate layer is preferably 5,000 or more, and more preferably from 10,000 to 300,000. A number average molecular weight thereof is preferably 1,000 or more, and more preferably from 2,000 to 250,000. The polydispersity (weight average molecular weight/number average molecular weight) thereof is preferably from 1.1 to 10.

The polymer compound for intermediate layer may be any of a random polymer, a block polymer, a graft polymer and the like, and it is preferably a random polymer.

Further, the polymer compound for intermediate layer may contain a monomer unit other than the monomer unit having a functional group capable of interacting with the surface of support, monomer unit having a hydrophilic group and monomer unit having a crosslinkable group. Other monomer unit is not particularly restricted and may be any monomer unit formed by copolymerization of a known monomer. Examples of the other monomer include a (meth)acrylate and a (meth)acrylamide.

The content of the other monomer unit in the polymer compound for intermediate layer is preferably 40% by mole or less, more preferably 30% by mole or less, and still more preferably 20% by mole or less, based on the total monomer unit of the polymer compound.

The polymer compound for intermediate layer may be used individually or in combination of two or more thereof.

A coating amount (solid content) of the intermediate layer is preferably from 0.1 to 100 mg/m², and more preferably from 1 to 30 mg/m².

The formation of Intermediate layer can be performed in a conventional manner. For instance, a method where the constituting component, for example, the polymer compound for undercoat layer, of the intermediate layer is dissolved in a solvent to prepare a coating solution and the coating solution is coated on the support is preferably used. Examples of the solvent include water, methanol and butanol.

According to the invention, the intermediate layer contains the hydroxycarboxylate salt. The content of the hydroxycarboxylate salt in the intermediate layer is preferably from 0.01 to 20% by weight, more preferably from 0.02 to 15% by weight, and particularly preferably from 0.05 to 10% by weight.

In order to incorporate the hydroxycarboxylate salt into the intermediate layer, the hydroxycarboxylate salt may be added to the coating solution in the preparation of intermediate layer.

### [Image-recording layer]

The image-recording layer (hereinafter, also referred to as a photosensitive layer) of the lithographic printing plate precursor according to the invention contains as the essential components, (A) a sensitizing dye, (B) a polymerization initiator, (C) a polymerizable compound and (D) a binder polymer.

### (A) Sensitizing dye

The sensitizing dye having an absorption maximum in a wavelength range from 300 to 450 nm is used.

Examples of the sensitizing dye having an absorption maximum in a wavelength range from 300 to 450 nm include merocyanines, benzopyranes, coumarins, aromatic ketones and anthracenes.

Of the sensitizing dyes having an absorption maximum in a wavelength range from 300 to 450 nm, a dye represented by formula (IX) shown below is more preferred in view of high sensitivity.

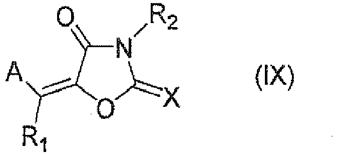

In formula (IX), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

The aromatic cyclic group which may have a substituent and heterocyclic group which may have a substituent represented by A in formula (IX) are same as the substituted or unsubstituted aryl group and substituted or unsubstituted aromatic heterocyclic residue described for any one of R₁, R₂ and R₃, respectively.

Specific examples of the sensitizing dye preferably used include compounds described in Paragraph Nos. [0047] to [0053] of JP-A-2007-58170.

Further, a sensitizing dye represented by formula (V) or (VI) shown below can also be used.

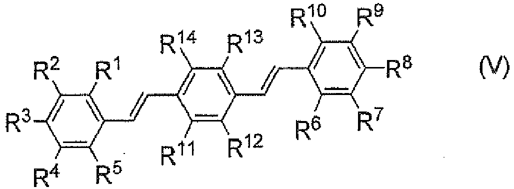

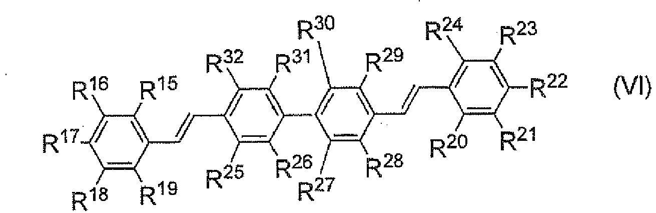

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Specific examples of such sensitizing dye preferably used include compounds described in EP-A-1349006 and WO 2005/029187.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

The amount of the sensitizing dye added is preferably in a range from 0.05 to 30 parts by weight, more preferably from 0.1 to 20 parts by weight, particularly preferably from 0.2 to 10 parts by weight, per 100 parts by weight of the total solid content of the photosensitive layer.

### (B) Polymerization initiator

The photosensitive layer contains a polymerization initiator (hereinafter, also referred to as an initiator compound). In the invention, a radical polymerization initiator is used.

As the initiator compound, a hexaarylbiimidazole compound is used.

The hexaarylbiimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The hexaarylbiimidazole compound is used together with the sensitizing dye having an absorption maximum in a wavelength range from 300 to 450 nm described above.

The amount of the polymerization initiator used in the photosensitive layer is preferably from 0.01 to 20% by weight, more preferably from 0.1 to 15% by weight, still more preferably from 1.0 to 10% by weight, based on the total solid content of the photosensitive layer. (C) Polymerizable compound

The polymerizable compound for use in the photosensitive layer is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used.

Also, a photo-oxidizable polymerizable compound described in JP-T-2007-506125 is preferred and a Polymerizable compound containing at least one urea group and/or tertiary amino group is particularly preferred. Specifically, the compound set forth below is exemplified.

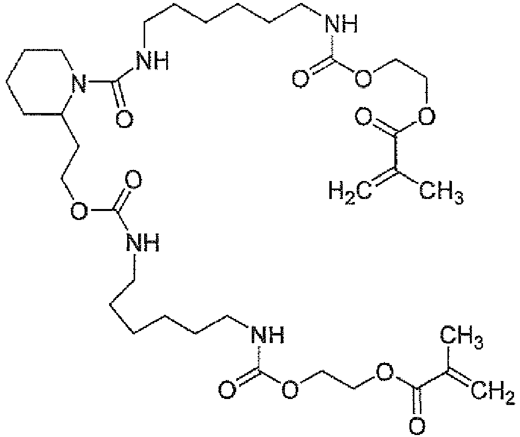

Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the photosensitive layer.

### (D) Binder polymer

The photosensitive layer contains a binder polymer. As the binder polymer, a polymer capable of holding the components of photosensitive layer on a support and capable of being removed with a developer is used. The binder polymer used includes a (meth)acrylic polymer, a polyurethane resin, a polyvinyl alcohol resin, a polyvinyl butyral resin, a polyvinyl formal resin, a polyamide resin, a polyester resin and an epoxy resin. Particularly, a (meth)acrylic polymer, a polyurethane resin or a polyvinyl butyral resin is preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups.

The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group with a compound having the acid group or the like.

One preferable example of the (meth)acrylic polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit having an acid group, a repeating unit derived from (meth)acrylic acid or a repeating unit represented by formula (I) shown below is preferably used.

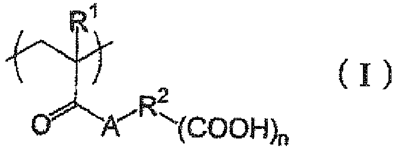

In formula (I), R¹ represents a hydrogen atom or a methyl group, R² represents a single bond or an (n+1) valent connecting group, A represents an oxygen atom or -NR³-, wherein R³ represents a hydrogen atom or a monovalent hydrocarbon group having from 1 to 10 carbon atoms, and n represents an integer from 1 to 5.

The connecting group represented by R² in formula (I) is constructed from a hydrogen atom, a carbon atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, more preferably a single bond, an alkylene group having from 1 to 5 carbon atoms or a substituted alkylene group having from 1 to 5 carbon atoms, and particularly preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and particularly preferably a hydrogen atom or a methyl group. n is preferably from 1 to 3, more preferably 1 or 2, and particularly preferably 1.

A ratio (% by mole) of the copolymerization component having a carboxylic acid group in the total copolymerization components of the (meth)acrylic polymer is preferably from 1 to 70% in view of developing property. Considering good compatibility between the developing property and printing durability, it is more preferably from 1 to 50%, and particularly preferably from 1 to 30%.

Further, a polyvinyl butyral resin having an acid group introduced, for example, a polyvinyl butyral resin represented by formula (II) shown below is also preferably used.

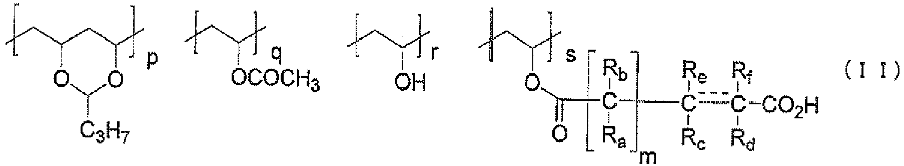

In formula (II), a ratio of each repeating unit p/q/r/s is preferably in a range from 50 to 78% by mole/from 1 to 5% by mole/from 5 to 28% by mole/from 5 to 20% by mole. Rₐ, R_{b}, R_{c}, R_{d}, Rₑ and R_{f} each independently represents a hydrogen atom or a monovalent substituent which may have a substituent, and m represents an integer from 0 to 1. Preferable examples of any one of Rₐ, R_{b}, R_{c}, R_{d}, Rₑ and R_{f} include a hydrogen atom, an alkyl group which may have a substituent, a halogen atom and an aryl group which may have a substituent. More preferable examples thereof include a hydrogen atom, a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may be combined with each other to form a ring structure. The bond between the carbon atom to which R_{c} and Rₑ connect and the carbon atom to which R_{d} and R_{f} connect is a single bond, a double bond or an aromatic double bond and in the case of the double bond or aromatic double bond, R_{c} and R_{d}, Rₑ and R_{f}, R_{c} and R_{f} or Rₑ and R_{d} are connected with each other to form a single bond.

Preferable specific examples of the repeating unit having a carboxylic acid group are set forth below.

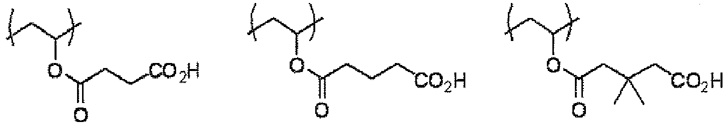

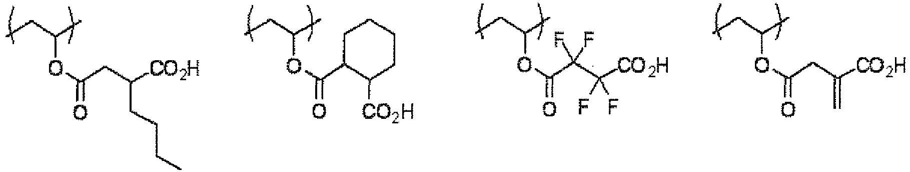

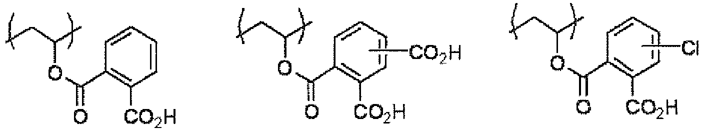

Moreover, the acid group of a polymer having an acid group which is a preferable example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

It is preferred that the binder polymer for use in the invention further contain a crosslinkable group. The term "crosslinkable group" as used herein means a group capable of crosslinking the binder polymer in the process of a radical polymerization reaction which is caused in the photosensitive layer, when the lithographic printing plate precursor is exposed to light The crosslinkable group is not particularly restricted as long as it has such a function and includes, for example, an ethylenically unsaturated bond group, an amino group and an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, particularly preferably from 0.1 to 2.0 mmol, per g of the binder polymer.

The binder polymer may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight.

According to the invention, by controlling a ratio of the polymerizable compound to the binder polymer contained in the photosensitive layer of the lithographic printing plate precursor, the permeability of developer into the photosensitive layer more increases and the developing property is further improved. Specifically, a weight ration of polymerizable compound/binder polymer in the photosensitive layer is preferably 1 or more, more preferably from 1 to 4.5, and most preferably from 1 to 3.

### <Other components for photosensitive layer>

The photosensitive layer preferably contains a chain transfer agent. As the chain transfer agent, for example, compounds having SH, PH, SiH or GeH in their molecules are used. The compound donates hydrogen to a low active radical species to generate a radical or is oxidized and deprotonized to generate a radical.

In particular, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used as the chain transfer agent in the photosensitive layer.

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity and a plasticizer for improving plasticity. As the additives, known compounds are used and, for example, compounds described in Paragraph Nos. [0161] to [0215] of JP-A-2007-206217 are used.

### <Formation of photosensitive layer>

The photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

Various methods can be used for the coating. Examples of the method include bar coater coating, spin coating, spray coating, curtain coating, dip coating, air knife coating, blade coating and roll coating.

The coating amount (solid content) of the photosensitive layer is preferably from 0.3 to 3.0 g/m²_{.}

### [Protective layer]

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. As a material for the protective layer, for example, a water-soluble polymer compound relatively excellent in crystallizability is preferably used. Specifically, when polyvinyl alcohol is used as a main component, the best results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and solubility in water. Also, polyvinyl alcohol may partly have other copolymer component. Polyvinyl alcohol is obtained by hydrolysis of polyvinyl acetate. As specific examples of the polyvinyl alcohol, those having a hydrolysis degree of 71 to 100% by mole and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). Polyvinyl alcohols can be used individually or as a mixture. The content of polyvinyl alcohol in the protective layer is preferably from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used.

As a component used as a mixture with polyvinyl alcohol, polyvinyl pyrrolidone or a modified product thereof is preferred from the viewpoint of the oxygen-blocking property and removability by development. The content thereof is ordinarily from 3.5 to 80% by weight, preferably from 10 to 60% by weight, more preferably from 15 to 30% by weight, in the protective layer.

As other component of the protective layer, glycerin, dipropylene glycol or the like can be added in an amount corresponding to several % by weight of the polymer compound to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount of several % by weight of the polymer compound.

Further, it is also preferred to incorporate an inorganic stratiform compound described in Paragraph Nos. [0018] to [0024] of JP-A-2006-106700 into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably from 0.05 to 10 g/m². When the protective layer contains the inorganic stratiform compound, it is more preferably from 0.1 to 5 g/m², and when the protective layer does not contain the inorganic stratiform compound, it is more preferably from 0.5 to 5 g/m².

### [Backcoat layer]

A backcoat layer can be provided on the back surface of the support, if desired. The backcoat layer preferably includes, for example, a layer comprising an organic polymer compound described in JP-A-5-45885 and a layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting materials are inexpensive and easily available.

### [Method of preparing lithographic printing plate]

The lithographic printing plate precursor according to the invention is exposed imagewise and then subjected to development processing to prepare a lithographic printing plate.

### <Image exposure step>

The lithographic printing plate precursor is, for example, exposed with a laser through a transparent original having a line image, a halftone dot image or the like, or imagewise exposed by scanning of a laser beam based on digital data.

The wavelength of the exposure light source is preferably from 300 to 450 nm.

The exposure mechanism may be any of an internal drum system, an external drum system and a flat bed system.

### <Development processing step>

In the invention, the method of developing uses a developer having a pH of 6.9 to 10.3.

It is possible to remove together the protective layer and the unexposed area of the photosensitive layer with the developer. Thus, the pre-water washing step is not particularly necessary. Further, it is preferred to incorporate a surfactant or a water-soluble polymer compound into the developer so that the development and gum solution treatment can be conducted at the same time. Thus, the post-water washing step is not particularly necessary, and after conducting the development and gum solution treatment with one solution, the drying step can be performed. After the development and gum treatment, the excess developer is preferably removed using a squeeze roller.

One preferred embodiment of the method of preparing a lithographic printing plate according to the invention is characterized by not containing a water washing step. In the above embodiment, the term "not containing a water washing step" means that any water washing step is not contained between the image exposure step and the completion of the preparation of a lithographic printing plate through the development processing step. Specifically, according to the embodiment, a lithographic printing plate is prepared without undergoing a water washing step not only between the image exposure step and the development processing step but also after the development processing step. The lithographic printing plate prepared can be used for printing as it is.

The development processing is performed at temperature from 0 to 60°C, preferably from about 15 to about 40°C in a conventional manner, for example, by a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush.

The development processing is preferably performed by an automatic development processor equipped with a supplying means for the developer and a rubbing member. An automatic development processor using a rotating brush roller as the rubbing member is particularly preferred. The number of the rotating brush rollers is preferably two or more. Further, the automatic development processor is preferably provided with a means for removing the excess developer, for example, a squeeze roller, or a drying means, for example, a hot air apparatus, subsequently to the development processing means. Further, the automatic development processor may be provided with a pre-heating means for conducting pre-heating treatment of the lithographic printing plate precursor after image exposure prior to the development processing means. The development processing by such an automatic development processor has an advantage in that it is free from the measures against development scum resulting from the protective layer and/or photosensitive layer encountered in the on-press development.

One example of the automatic development processor for use in the method of preparing a lithographic printing plate according to the invention is briefly described with reference to Fig. 1.

An automatic development processor 100 shown in Fig.1 comprises a chamber the outer shape of which is formed by a machine casing 202 and has a pre-heating unit 200, a developing unit 300 and a drying unit 400 continuously formed along a transporting direction (arrow A) of a transporting pass 11 for a lithographic printing plate precursor.

The pre-heating unit 200 comprises a heating chamber 208 having a transporting inlet 212 and a transporting outlet 218 and a skewer roller 210, a heater 214 and a circulation fan 216 are arranged in the inside thereof.

The developing unit 300 is separated from the pre-heating unit 200 by an outer panel 310 and a slit type insertion slot 312 is formed in the outer panel 310.

In the inside of the developing unit 300, a processing tank 306 having a developing tank 308 filled with a developer and an insertion roller pair 304 for guiding the lithographic printing plate precursor into the inside of the processing tank 306 are disposed. A shielding cover 324 is located above the developing tank 308.

In the inside of the developing tank 308, a guide roller 344 and a guide member 342, a submerged roller pair 316, a brush roller pair 322, a brush roller pair 326 and a carrying-out roller pair 318 are provided in order from the upstream side of the transporting direction of lithographic printing plate precursor. The lithographic printing plate precursor transported into the developing tank 308 is immersed in the developer and the non-image area is removed by passing between the rotating brush roller pairs 322 and 326.

A spray pipe 330 is provided under the brush roller pairs 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.

To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, an upper limit liquid level meter 52 and a lower limit liquid level meter 53 are provided.

The developing tank 308 is also connected to a water tank for replenishment 71 through a third circulation pipeline C3. A water-replenishing pump 72 is located in the third circulation pipeline C3 and water pooled in the water tank for replenishment 71 is supplied to the developing bath 308 by the water-replenishing pump 72.

A liquid temperature sensor 336 is provided on the upstream side of the submerged roller pair 316. A liquid level meter 338 is provided on the upstream side of the carrying-out roller pair 318.

In a partition board 332 placed between the developing unit 300 and the drying unit 400, a slit type pass-through slot 334 is formed. Also, a shutter (not shown) is provided along a passage between the developing unit 300 and the drying unit 400 and the passage is closed by the shutter when the lithographic printing plate precursor does not pass through the passage.

In the drying unit 400, a support roller 402, ducts 410 and 412, a transport roller pair 406, ducts 410 and 412 and a transport roller pair 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the resulting lithographic printing plate dried by the drying means is discharged through the discharge slot 404.

The developer for use in the invention is an aqueous solution having pH of 6.9 to 10.3 and containing water as the main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred.

The anionic surfactant for use in the developer is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-alkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly limited and hitherto known cationic surfactants may be used. For example, alkylamine salts, quaternary ammonium salts, alkylimidazolinium salts, polyoxyethylene alkyl amine salts and polyethylene polyamine derivatives are exemplified.

The nonionic surfactant for use in the developer is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant for use in the developer is not particularly limited and includes, for example, amine oxide type, for example, alkyldimethylamine oxide, betaine type, for example, alkyl betaine and amino acid type, for example, sodium salt of alkylamino fatty acid.

In Particular, an alkyldimethylamine oxide which may have a substituent, an alkyl carboxy betaine which may have a substituent and an alkyl sulfo betaine which may have a substituent are preferably used. Specific examples of the compound are described, for example, in Paragraph Nos. [0255] to [0278] of JP-A-2008-203359 and Paragraph Nos. [0028] to [0052] of JP-A-2008-276166.

Two or more of the surfactants may be used in combination. The content of the surfactant in the developer is preferably from 0.01 to 20% by weight, and more preferably from 0.1 to 10% by weight.

The water-soluble polymer compound for use in the developer includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

Into the developer, a pH buffer agent may further be incorporated. As the pH buffer agent, a pH buffer agent exhibiting a pH buffer function at pH 6.9 to 10.3 is used. In the invention, a weak alkaline buffer agent is used and includes (i) a carbonate ion and a hydrogen carbonate ion or (ii) a water-soluble amine compound and an ion of the amine compound. The pH buffer agent exhibits a pH buffer function in the developer to prevent fluctuation of the pH even when the developer is used for a long period of time. As a result, for example, the deterioration of developing property resulting from the fluctuation of pH and the occurrence of development scum are restrained.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

The total amount of the carbonate ion and hydrogen carbonate ion is preferably from 0.05 to 5 mole/1, more preferably from 0.1 to 2 mole/1, particularly preferably from 0.2 to 1 mole/1, in the developer. When the total amount is 0.05 mole/l or more, the developing property and processing ability are not degraded. When the total amount is 5 mole/l or less, precipitates and crystals hardly generate and since gelation at neutralization of waste liquid of the developer hardly occur, treatment of the waste liquid can be carried out without trouble.

The water-soluble amine compound is not particularly restricted and preferably a water-soluble amine compound having a group capable of facilitating water solubility. The group capable of facilitating water solubility includes, for example, a carboxylic acid group, a sulfonic acid group, a sulfinic acid group, a phosphonic acid group and a hydroxy group. The water-soluble amine compound may have two or more groups capable of facilitating water solubility.

In the case where the water solubility of the water-soluble amine compound is facilitated with a carboxylic acid group, a sulfonic acid group, a sulfinic acid group or a phosphonic acid group, the water-soluble amine compound corresponds to an amino acid. The amino acid is held in equilibrium in an aqueous solution and, for example, when the acid group is a carboxylic acid group, the equilibrium state is indicated as below. The amino acid means State B shown below and an amino acid ion means State C shown below. A counter ion in State C is preferably a sodium ion or a potassium ion.

### Equilibrium state of amino acid (case wherein acid group is carboxylic acid group)

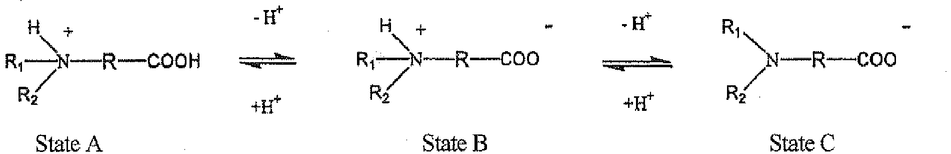

wherein, for example, R₁ and R₂ each independently represents a hydrogen atom, an alkyl group, an aryl group or the like, and R represents a connecting group.

Specific examples of the water-soluble amine compound having a carboxylic acid group, a sulfonic acid group or a sulfinic acid group include an amino acid, for example, glycine, iminodiacatic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphatic amine sulfonic acid, for example, taurine, and an aliphatic amine sulfinic acid, for example, aminoethanesulfinic acid. Among them, glycine or iminodiacetic acid is preferred.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid and ethylenediaminopentamethylenephosphonic acid. Particularly, 2-aminoethylphosphonic acid is preferred.

The water-soluble amine compound having a hydroxy group as the group capable of facilitating water solubility means an alkylamine (State B shown below) having a hydroxy group in its alkyl group and its ion means an ammonium ion (State A shown below) of the amino group. 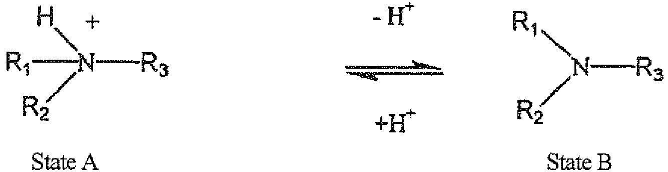 wherein, for example, R₁, R₂ and R₃ each independently represents a hydrogen atom, an alkyl group, an aryl group or the like, provided that at least one of R₁, R₂ and R₃ represents an alkyl group having a hydroxy group.

Specific examples of the water-soluble amine compound having a hydroxy group include monoethanol amine, diethanol amine, trimethanol amine, triethanol amine, tripropanol amine and triisopropanol amine. Among them, triethanol amine or diethanol amine is preferred. A counter ion of the ammonium ion is preferably a chloride ion.

The ion of a water-soluble amine compound may be generated in an aqueous solution of the water-soluble amine compound. To the aqueous solution of water-soluble amine compound may be added an alkali or an acid. Alternatively, the ion of a water-soluble amine compound may be contained in an aqueous solution by adding a compound which is a salt of water-soluble amine compound per se.

The total amount of the water-soluble amine compound and ion of the amine compound is preferably from 0.01 to 1 mole/1, more preferably from 0.03 to 0.7 mole/1, particularly preferably from 0.05 to 0.5 mole/1, in the developer. When the total amount of water-soluble amine compound and ion of the amine compound is in the range described above, the developing property and processing ability are not degraded and treatment of the waste liquid can be easily carried out.

The alkali for use in the adjustment of pH described above includes, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent and a combination thereof. The acid for use in the adjustment of pH includes, for example, an inorganic acid, for example, hydrochloric acid, sulfuric acid or nitric acid. By adding such an alkali or acid, the pH can be finely adjusted.

For the purpose of finely adjusting the alkali concentration or aiding dissolution of the photosensitive layer in the non-image area, an alkali agent, for example, an organic alkali agent may be supplementarily used together. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The supplementary alkali agents may be used individually or in combination of two or more thereof.

The developer may contain an organic solvent. As the organic solvent capable of being contained, for example, an aliphatic hydrocarbon (e.g., hexane, heptane, Isopar E, Isopar H, Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

When the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer may contain an enzyme, preferably a hydrolytic enzyme. By processing with the developer containing an enzyme, improvement in the stain preventing property and prevention of the occurrence of development scum can be achieved because the ethylenically unsaturated compound is hydrolyzed in the developer to increase hydrophilicity. Further, in the case of hydrolysis of an ester group, since polarity conversion (polarity conversion from hydrophobicity to hydrophilicity) is utilized, penetration of the developer into the image area hardly occurs so that the improvement in the stain preventing property and prevention of the occurrence of development scum can be achieved while maintaining the sensitivity and printing durability.

With respect to the enzyme for use in the invention, the kind thereof is not particularly restricted, as long as the enzyme has a function of preventing the occurrence of development scum in the development processing of a lithographic printing plate precursor having a photopolymerizable photosensitive layer. The groups of enzymes as described in Koso Handbook (Enzyme Handbook) Third Edition edited by Tatsuhiko Yagi et al, Asakura Publishing Co., Ltd. are appropriately used. In particular, for the purpose of decomposition and solubilization of the polymerizable compound (ethylenically unsaturated compound), the hydrolytic enzymes belonging to the enzyme number (EC number) of Group EC3. by Enzyme Commission of Congress of Biochemistry and Molecular Biology (IUBMB) are preferably used. Since the ethylenically unsaturated compounds are composed, for example, of a carbon atom, a hydrogen atom, a nitrogen atom, an oxygen atom, a sulfur atom, a phosphorus atom and a halogen atom in many cases, an enzyme capable of hydrolyzing a carboxylic acid ester bond, an enzyme capable of hydrolyzing a phosphoric acid ester, an enzyme capable of hydrolyzing a sulfuric acid ester, an enzyme capable of hydrolyzing an ether bond, an enzyme capable of hydrolyzing a thioether bond, an enzyme capable of hydrolyzing a peptide bond, an enzyme capable of hydrolyzing a carbon-carbon bond, an enzyme capable of hydrolyzing a carbon-halogen bond and the like are exemplified as preferred enzymes. The enzymes capable of hydrolyzing at least one member selected from the group consisting of an ester bond, an amido bond, a tertiary amino group, a urethane bond, a urea bond, a thiourethane bond and a thiourea bond are more preferred.

Of the enzymes, those belonging to Group EC3.1 (ester hydrolytic enzyme) and Group EC3.4 (peptide bond hydrolytic enzyme) are preferred, and EC3.1.1.3 (triacylglycerol lipase), EC3.4.11.1 (leucyl aminopeptidase), EC3.4.21.62 (subtilisin), EC3.4.21.63 (oryzin), EC3.4.22.2 (papain), EC3.4.22.32 (stem bromelain), EC3.4.23.18 (aspergillopepsin I), EC3.4.24.25 (vibriolysin), EC3.4.24.27 (thermolysin) and EC3.4.24.28 (bacillolysin) are preferred. Further, EC3.1.1.3, EC3.4.21.14, EC3.4.21.62 and EC3.4.21.63 are most preferred.

As described above, in view of the developing property and environment the pH of the developer is from 6.9 to 10.3.

From this point of view, as the enzyme, an alkali enzyme is preferably used. The term "alkali enzyme" as used herein means an enzyme which has an optimum pH range in an alkaline range. The enzyme having the optimum pH range from 7.0 to 11.0 is preferred. The enzyme having an optimum temperature range from 20 to 60°C is preferred, and that having an optimum temperature range from 30 to 55°C is more preferred.

Specifically, an enzyme capable of mainly hydrolyzing an ester group of the polymerizable compound under an alkali condition, for example, alkali protease or alkali lipase is preferred. As the alkali protease, enzymes of microbial origin, for example, Bacillus subtilis, Aspergillus oryzae, Bacillus stearothermophilus, papaya latex, papaya, Ananas comosus M, Pig pancreas, Bacillus licheniformis, Aspergillus melleus, Aspergillus sp., Bacillus lentus, Bacillus sp. and Bacillus clausii are exemplified. As the alkali lipase, enzymes of microbial origin, for example, Candida cylindracea, Humicola lanuginosa, Psudomonas, Mucor sp., Chromobacterium viscosum, Rhizopus japonics, Aspergillus niger, Mucor javanicus, Penicillium camemberti, Rhizopus oryzae, Candida rugosa, Penicillium roqueforti, Rhizopus delemar, Psendomonas sp., Aspergillus sp., Rhizomucor miehei, Bacillus sp. and Alcaligenes sp. are exemplified.

More specifically, Lipase PL, Lipase QLM, Lipase SL, Lipase MY and Lipase OF (produced by Dai-Nippon Meiji Sugar Co., Ltd.), Newlase F3G, Lipase A "Amano", Lipase AY "Amano" 30G, Lipase G "Amano" 50, Lipase R "Amano", Lipase AS "Amano", Umamizayme G, Papain W-40, Protease A "Amano" G, Protease N "Amano" G, Protease NL "Amano", Protease P "Amano" 3G, Protease S "Amano" G, Bromelain F, Proleather FG-F, Peptidase R, Thermoase PC10F, Protin SD-AC10F, Protin SD-AY10, Protin SD-PC10F, Protin SD-NY10, Spleen digestive enzyme TA, Prozyme, Prozyme 6, Semi-Alkaline Proteinase, Lipase AYS "Amano", Lipase PS "amino" SD, Lipase AK "Amano", Lipase PS "Amano" IM, Protease N "Amano", Protease S "Amano", Acylase "Amano" and D-Amino acylase "Amano" (produced by Amano Enzyme Inc.), Alcalase, Espelase, Sabinase, Ebalase, Kannase, Lipolase, Lipex, NS44020, NS44120, NS44060, NS44114, NS44126 and NS44160 produced by Novozymes Japan Ltd.), Alkaline protease (produced by Takeda Chemical Industries, Ltd.), Aroase XA-10 (produced by Yakult Pharmaceutical Industry Co., Ltd.), Alkali Protease GL, Protex 6L, Purafect, Purafect OX, Propelase, Protex OXG and Protex 40L (produced by Genencor Kyowa Co., Ltd.), Sumizyme MP (produced by Shin-Nihon Kagaku Kogyo Co., Ltd.), Bioplase OP, Bioplase AL-15KG, Bioplase 30G, Bioplase APL-30, Bioplase XL-416F, Bioplase SP-20FG, Bioplase SP-4FG and Protease CL-15 (produced by Nagase Chemtex Corp.), Orientase (produced by HBI Enzymes Inc.) and Enzylon SA (produced by Rakuto Kasei Industry Co., Ltd.).

With respect to the method for introduction of the enzyme, the enzyme may be directly incorporated into the developer or may be added at the time of processing of a lithographic printing plate precursor. Also, the development processing may be conducted while supplying the enzyme to the developer.

The amount of the enzyme added is preferably from 0.0001 to 5% by weight, more preferably from 0.001 to 1% by weight, particularly preferably from 0.001 to 0.3% by weight, based on the total amount of the developer.

The developer may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer can be used as a developer and a development replenisher for the exposed lithographic printing plate precursor. The developer can be preferably applied to the automatic development processor described above. In the case of conducting the development processing using an automatic development processor, the developer becomes fatigued in accordance with the processing amount, and hence the processing ability may be restored using a replenisher or a fresh developer.

In the method of preparing a lithographic printing plate according to the invention, the lithographic printing plate precursor may be heated its entire surface before the exposure, during the exposure or between the exposure and the development, if desired. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions and is ordinarily carried out in a temperature range of 100 to 500°C. When the temperature is too low, a sufficient effect of strengthening the image may not be obtained, whereas when it is excessively high, problems of deterioration of the support and thermal decomposition of the image area may occur sometimes.

### EXAMPLES

The present invention will be described in more detail with reference to the following examples, but the invention should not be construed as being limited thereto. In the examples below, unless otherwise indicated particularly, a ratio of monomer unit means a molar ratio and a molecular weight means a weight average molecular weight in a polymer.

### Examples 1 to 91 and Comparative Examples 1 to 19

Examples 1-9, 26-33, 50-80, 81, 83, 85-87, 94, 95, are comparative examples.

### <Preparation of Supports 1 to 3>

Surface treated supports 5-13 fall outside the scope of the claims. An aluminum plate (JIS A1050) having a thickness of 0.3 mm was subjected to surface treatment shown below.

### (a) Mechanical surface roughening treatment

Mechanical surface roughening treatment of the aluminum plate was conducted by means of rotating roller-form nylon brushes while supplying a suspension (having specific gravity of 1.12) of an abrasive (pumice) in water as an abrasion slurry solution to the surface of the aluminum plate. The average particle size of the abrasive was 30 µm and the maximum particle size was 100 µm. The material of the nylon brush was 6·10 nylon and the brush had a bristle length of 45 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) provided under the brush rollers were spaced 300 mm. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brushes was 200 rpm.

### (b) Alkali etching treatment

Alkali etching treatment of the aluminum plate was conducted by spraying an aqueous solution having sodium hydroxide concentration of 26% by weight, aluminum ion concentration of 6.5% by weight and temperature of 70°C to dissolve the aluminum plate in an amount of 10 g/m², followed by washing with water by spraying.

### (c) Desmut treatment

Desmut treatment of the aluminum plate was conducted by spraying an aqueous 1% by weight nitric acid solution (containing 0.5% by weight of aluminum ion) having temperature of 30°C, followed by washing with water by spraying. As the aqueous nitric acid solution for the desmut treatment, a waste solution from the process of electrochemical surface roughening treatment using alternating current in an aqueous nitric acid solution described below was used.

### (d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric amount was 220 C/dm² in terms of the total electric quantity during the aluminum plate functioning as an anode. To the auxiliary anode, 5% of the current from the electric source was divided. Subsequently, the plate was washed with water by spraying.

### (e) Alkali etching treatment

Alkali etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.50 g/m². Thus, the smut component mainly comprising aluminum hydroxide formed in the precedent process of electrochemical surface roughening treatment using alternating current was removed and an edge portion of the pit formed was dissolved to smoothen the edge portion. Subsequently, the plate was washed with water by spraying.

### (f) Desmut treatment

Desmut treatment of the aluminum plate was conducted by spraying an aqueous 15% by weight sulfuric acid solution (containing 4.5% by weight of aluminum ion) having temperature of 30°C, followed by washing with water by spraying.

### (g) Electrochemical surface roughening treatment

Electrochemical surface roughening treatment of the aluminum plate was continuously conducted by applying 60 Hz alternating current voltage. The electrolytic solution used was an aqueous solution containing 5.0 g/liter of hydrochloric acid (containing 5 g/liter of aluminum ion) and the solution temperature was 35°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 25 A/dm² at the peak current, and the electric amount was 50 C/dm² in terms of the total electric quantity during the aluminum plate functioning as an anode. Subsequently, the plate was washed with water by spraying.

### (h) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). The electrolytic solution supplied to the first electrolytic unit and second electrolytic unit was an aqueous solution having sulfuric acid concentration of 50 g/liter (containing 0.5% by weight of aluminum ion) and the solution temperature was 20°C. Subsequently, the plate was washed with water by spraying. The amount of the final anodic oxide film was 2.7 g/m².

The aluminum plate subjected to conducting all steps (a) to (h) was referred to as Support 1. The aluminum plate subjected to conducting only steps (d) to (h) was referred to as Support 2. The aluminum plate subjected to conducting only steps (d) to (f) and (h) was referred to as Support 3. The center line average roughness (Ra indication according to JIS B0601) of each support was measured using a stylus having a diameter of 2 µm and it was found that the center line average roughness of Support 1, Support 2 and Support 3 were 0.52 µm, 0.28 µm and 0.25 µm, respectively.

### <Preparation of Support 4>

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate was subjected to an anodizing treatment under conditions of current density of 10 A/dm² and voltage of 15 V in an aqueous 15% by weight sulfuric acid solution at 25°C for one minute to prepare Support 4. The center line average roughness (Ra indication according to JIS B0601) of the support was measured and found to be 0.44 µm.

### <Preparation of Surface treated supports 5 to 20>

Each of Supports 1 to 4 was immersed in a surface treatment solution (40°C) shown below for 10 seconds, washed with tap water of 20°C for 2 seconds and died at 100°C for 10 seconds to conduct surface treatment of the support, whereby Surface treated supports 5 to 20 were prepared, respectively.

### (Surface treatment solution)

| | |
|---|---|
| Polyvinyl phosphonic acid | 4 g |
| Hydroxycarboxylate salt or comparative compound shown in Table 1 | 0.4 g |
| Tap water | 1,000 g |

**TABLE 1**

| Surface Treated Support | Support | Hydroxycarboxylate Salt or Comparative Compound |
|---|---|---|
| 5 | 1 | Sodium gluconate |
| 6 | 2 | Sodium gluconate |
| 7 | 3 | Sodium gluconate |
| 8 | 4 | Sodium gluconate |
| 9 | 3 | Disodium tartrate |
| 10 | 3 | Trisodium citrate |
| 11 | 3 | Disodium malate |
| 12 | 3 | Sodium cerebronate |
| 13 | 3 | Sodium carminate |
| 14 | 1 | None |
| 15 | 2 | None |
| 16 | 3 | None |
| 17 | 4 | None |
| 18 | 3 | Sodium benzoate |
| 19 | 3 | Sodium acetate |
| 20 | 3 | Pentaerythritol |

### <Formation of Intermediate layer>

Intermediate layers 30, 32, 39-42 fall outside the scope of the claims. Coating solution 1 for Intermediate layer shown below was coated on each of Supports 1 to 4 so as to have a dry coating amount of 12 mg/m² using a bar coater and dried at 80°C for 20 seconds to form Intermediate layers 21 to 30, respectively.

### (Coating solution 1 for intermediate layer)

| | |
|---|---|
| Polymer (SP-1) shown below | 1.9 g |
| Hydroxycarboxylate salt shown in Table 2 | 0.2 g |
| Pure water | 60.0 g |
| Methanol | 939.7 g |

### Polymer (SP-1) (weight average molecular weight: 100,000)

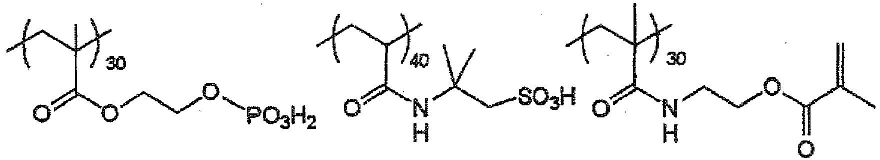

Coating solution 2 for intermediate layer shown below was coated on Support 3 so as to have a dry coating amount of 12 mg/m² using a bar coater and dried at 100°C for 20 seconds to form Intermediate layers 31 and 32, respectively.

### (Coating solution 2 for intermediate layer)

| | |
|---|---|
| Polymer (SP-2) shown below | 1.6 g |
| Hydroxycarboxylate salt shown in Table 2 | 0.1 g |
| Pure water | 1,000.0 g |

### Polymer (SP-2) (weight average molecular weight: 30,000)

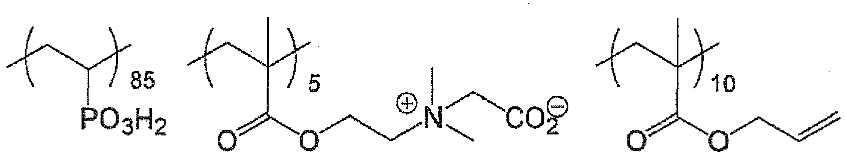

Coating solution 3 for intermediate layer shown below was coated on Support 3 so as to have a dry coating amount of 12 mg/m² using a bar coater and dried at 100°C for 20 seconds to form Intermediate layers 33 to 42, respectively.

### (Coating solution 3 for intermediate layer)

| | |
|---|---|
| Polymer (SP-3) shown below | 0.87 g |
| Polymer (SP-4) shown below | 0.73 g |
| Hydroxycarboxylate salt or comparative compound shown in Table 2 | 0.1 g |
| Pure water | 1,000.0 g |

### Polymer (SP-3) (weight average molecular weight: 30,000)

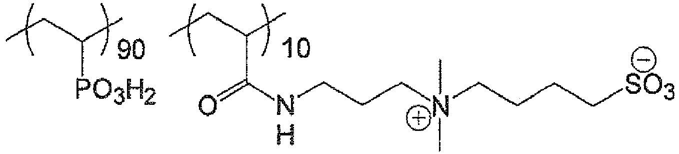

### Polymer (SP-4) (weight average molecular weight: 30,000)

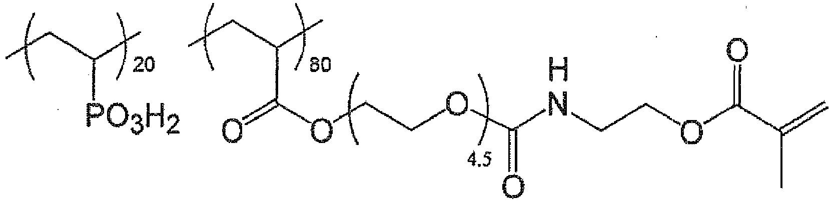

**TABLE 2**

| Intermediate Layer | Support | Hydroxycarboxylate Salt or Comparative Compound |
|---|---|---|
| 21 | 1 | Sodium gluconate |
| 22 | 2 | Sodium gluconate |
| 23 | 3 | Sodium gluconate |
| 24 | 4 | Sodium gluconate |
| 25 | 3 | Disodium tartrate |
| 26 | 3 | Trisodium citrate |
| 27 | 3 | Disodium malate |
| 28 | 3 | Sodium cerebronate |
| 29 | 3 | Sodium carminate |
| 30 | 3 | None |
| 31 | 3 | Sodium gluconate |
| 32 | 3 | None |
| 33 | 3 | Sodium gluconate |
| 34 | 3 | Disodium tartrate |
| 35 | 3 | Trisodium citrate |
| 36 | 3 | Disodium malate |
| 37 | 3 | Sodium cerebronate |
| 38 | 3 | Sodium carminate |
| 39 | 3 | None |
| 40 | 3 | Sodium benzoate |
| 41 | 3 | Sodium acetate |
| 42 | 3 | Pentaerythritol |

### <Formation of Photosensitive layer>

Coating solution 1 for photosensitive layer having the composition shown below was coated so as to have a dry coating amount of 1.4 g/m² and dried at 100°C for one minute to form Photosensitive layers 1 to 7, respectively.

### <Coating solution 1 for photosensitive layer>

| | |
|---|---|
| Polymerizable compound (Compound A shown below) | 4.0 parts by weight |
| Binder polymer (Binder A shown below) (weight average molecular weight: 30,000) | 2.0 parts by weight |
| Sensitizing Dye (C-1) shown below | 0.32 parts by weight |
| Polymerization Initiator (D-1) shown below | 0.61 parts by weight |
| Hydroxycarboxylate salt shown in Table 3 | 0.10 parts by weight |
| Chain Transfer Agent (E-1) shown below | 0.57 parts by weight |
| N-Nitrosophenylhydroxylamine aluminum salt | 0.020 part by weight |
| Dispersion of ε-phthalocyanine | 0.71 parts by weight |
| (pigment: 15% by weight; dispersing agent (Polymer (1) shown below (weight average molecular weight: 60,000)): 10% by weight; solvent (cyclohexanone/methoxypropyl acetate/1-methoxy-2-propanol = 15% by weight/20% by weight/40% by weight)) | |
| Fluorine-based nonionic surfactant (MEGAFAC F780, produced by Dainippon Ink & Chemicals, Inc.)) | 0.016 part by weight |
| Methyl ethyl ketone | 47 parts by weight |
| Propylene glycol monomethyl ether | 45 parts by weight |

Compound A 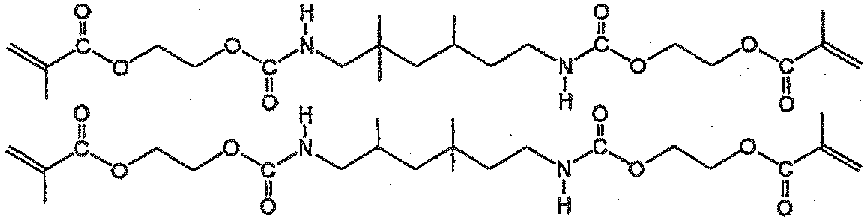 Mixture of the isomers described above

### Binder A

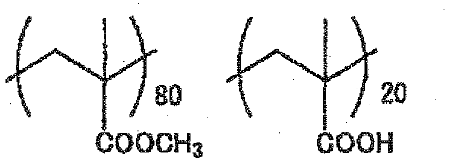

### Polymer (1)

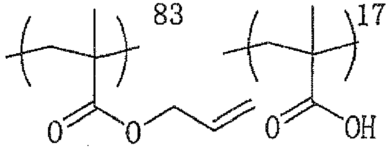

### Sensitizing Dye (C-1)

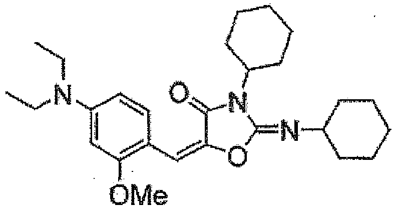

### Polymerization Initiator (D-1)

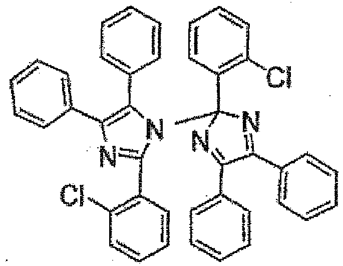

### Chain Transfer Agent (E-1)

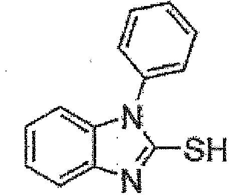

Coating solution 2 for photosensitive layer having the composition shown below was coated using a bar and dried in an oven at 90°C for 60 seconds to form Photosensitive layers 8 to 15 each having a dry coating amount of 1.3 g/m², respectively.

### <Coating solution 2 for photosensitive layer>

| | |
|---|---|
| Binder Polymer (1) shown below (weight average molecular weight: 50,000) | 0.04 g |
| Binder Polymer (2) shown below (weight average molecular weight: 80,000) | 0.30 g |
| Polymerizable Compound (2) shown below | 0.17 g |
| (PLEX 6661-O, produced by Degussa Japan Co. Ltd.) | |
| Polymerizable Compound (Compound A shown above) | 0.51 g |
| Hydroxycarboxylate salt or comparative compound shown in Table 3 | 0.01 g |
| Sensitizing Dye (1) shown below | 0.03 g |
| Sensitizing Dye (2) shown below | 0.015 g |
| Sensitizing Dye (3) shown below | 0.015 g |
| Polymerization Initiator (1) shown below | 0.13 g |
| Chain Transfer Agent Mercaptobenzothiazole | 0.01 g |
| Dispersion of ε-phthalocyanine pigment | 0.40 g |
| (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| Thermal polymerization inhibitor | 0.01 g |
| N-Nitrosophenylhydroxylamine aluminum salt | |
| Fluorine-Based Surfactant (1) shown below (weight average molecular weight: 10,000) | 0.001 g |
| 1-Methoxy-2-propanol | 3.5 g |
| Methyl ethyl ketone | 8.0 g |

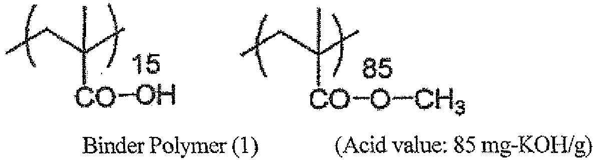

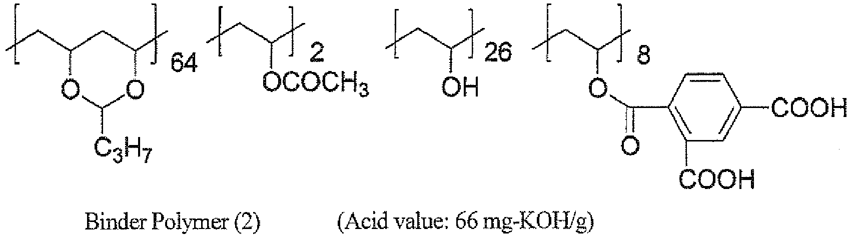

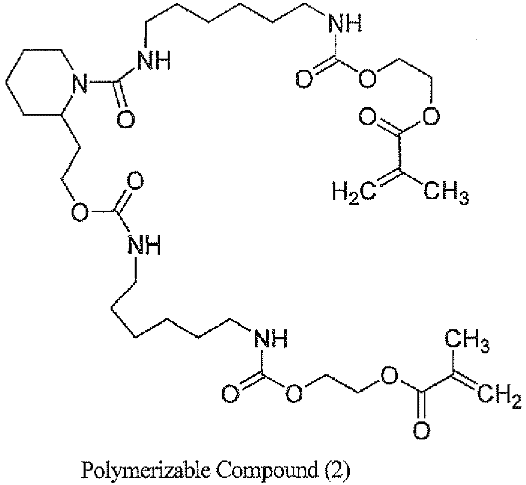

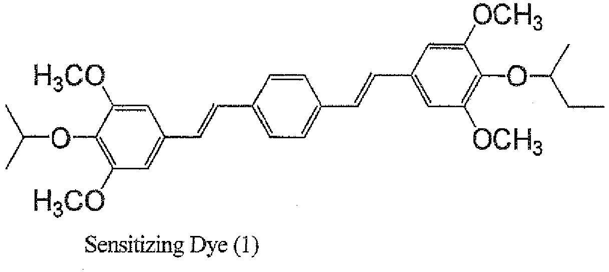

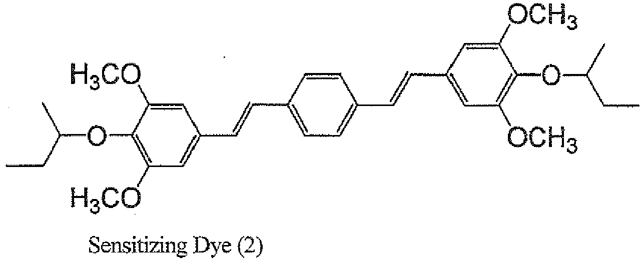

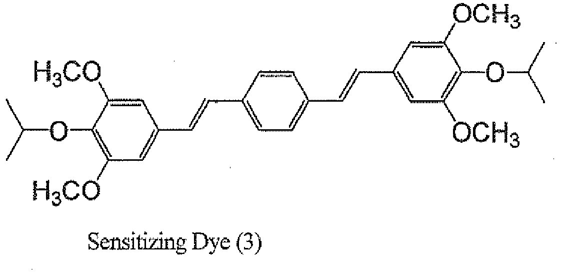

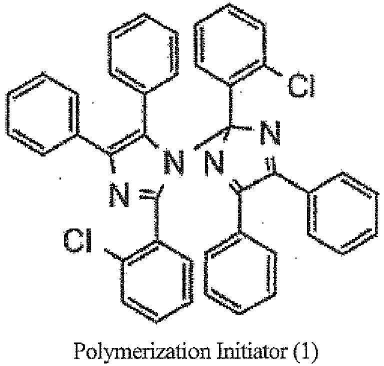

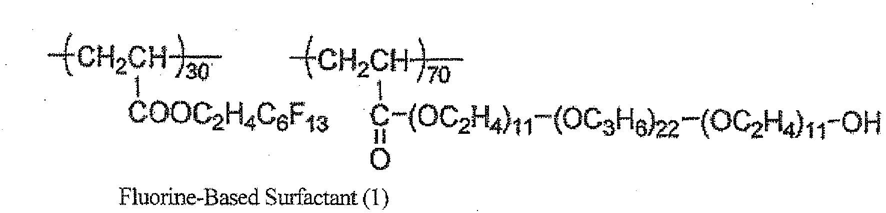

**TABLE 3**

| Photosensitive Layer | Coating Solution for Photosensitive Layer | Hydroxycarboxylate Salt or Comparative Compound |
|---|---|---|
| 1 | 1 | Ammonium gluconate |
| 2 | 1 | Ammonium tartrate |
| 3 | 1 | Ammoniun citrate |
| 4 | 1 | Ammonium malate |
| 5 | 1 | Ammonium cerebronate |
| 6 | 1 | Ammonium carminate |
| 7 | 1 | None |
| 8 | 2 | Ammonium gluconate |
| 9 | 2 | Ammonium tartrate |
| 10 | 2 | Ammonium citrate |
| 11 | 2 | Ammonium malate |
| 12 | 2 | None |
| 13 | 2 | Ammonium benzoate |
| 14 | 2 | Ammonium acetate |
| 15 | 2 | Pentaerythritol |

### <Formation of Protective layer>

Coating solution 1 for protective layer having the composition shown below was coated using a bar and dried at 125°C for 70 seconds to form Protective layer 1 having a dry coating amount of 1.8 g/m².

### (Coating solution 1 for protective layer)

| | |
|---|---|
| Dispersion of mica shown below | 0.6 g |
| Sulfonic acid-modified polyvinyl alcohol (GOSERAN CKS-50, produced by Nippon Synthetic Chemical Industry Co., Ltd. (saponification degree: 99% by mole; average polymerization degree: 300; modification degree: about 0.4% by mole)) | 0.8 g |
| Vinyl pyrrolidone/vinyl acetate (1/1) copolymer (weight average molecular weight: 70,000) | 0.001 g |
| Surfactant (EMALEX 710, produced by Nihon Emulsion Co., | 0.002 g |
| Ltd.) | |
| Water | 13 g |

### (Dispersion of mica)

In 368 g of water was added 32 g of synthetic mica (SOMASIF ME-100, produced by CO-OP Chemical Co., Ltd.; aspect ratio: 1,000 or more) and the mixture was dispersed using a homogenizer until the average particle diameter (measured by a laser scattering method) became 0.5 µm to obtain dispersion of mica.

Coating solution 2 for protective layer having the composition shown below was coated using a bar and dried at 120°C for 70 seconds to form Protective layer 2 having a dry coating amount of 1.25 g/m².

### <Coating solution 2 for protective layer>

| | |
|---|---|
| PVA-205 (partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)) | 0.658 g |
| PVA-105 (fully hydrolyzed polyvinyl alcohol, produced by Kuraray Co., Ltd. (saponification degree: 98.0 to 99.0% by mole; viscosity: 5.2 to 6.0 mPa·s in a 4% by weight aqueous solution at 20°C)) | 0.142 g |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

Surface treated supports 5 to 20, Intermediate layers 21 to 42, Photosensitive layers 1 to 15 and Protective layers 1 to 2 were combined as shown in Tables 4 to 6 below to prepare various lithographic printing plate precursors.

### <Exposure, Development and Printing>

Each of the lithographic printing plate precursors was subjected to image exposure by Violet semiconductor laser plate setter Vx9600 (having InGaN semiconductor laser (emission wavelength: 405 nm ± 10 nm/output: 30 mW)) produced by FFEI Ltd. The image exposure was performed at resolution of 2,438 dpi with halftone dots of 50% using FM screen (TAFFETA 20, produced by FUJIFILM Corp.) in a plate surface exposure amount of 0.05 mJ/cm².

The exposed lithographic printing plate precursor was subjected to development processing in an automatic development processor having a structure as shown in Fig. 1 using each developer having the composition shown below. The temperature of the pre-heating unit was 110°C. The temperature of the developer was 25°C. The transportation of the lithographic printing plate precursor was performed at transporting speed of 100 cm/min. After the development processing, drying was performed in the drying unit. The temperature for drying was 80°C.

**(Developer 1)**

| | |
|---|---|
| Surfactant-1 (SOFTAZOLINE LPB-R, produced by Kawaken Fine Chemicals Co., Ltd.) | 150 parts by weight |
| Surfactant-2 (SOFTAZOLINE LAO, produced by Kawaken Fine Chemicals Co., Ltd.) | 40 parts by weight |
| Chelating agent: Trisodium ethylenediaminesuccinate (OCTAQUEST E30, produced by Innospec Specialty Chemicals Inc.) | 6.8 parts by weight |
| 2-Bromo-2-nitropropane-1,3-diol | 0.25 parts by weight |
| 2-Methyl-4-isothiazoline-3-one | 0.25 parts by weight |
| Silicone type deforming agent: (TSA 739, produced by GE Toshiba Silicone Co., Ltd.) | 1.5 parts by weight |
| Sodium carbonate | 10.6 parts by weight |
| Sodium hydrogen carbonate | 5.2 parts by weight |
| Water | 785.4 parts by weight |

The pH was adjusted to 9.8 with sodium hydroxide and hydrochloric acid.

**(Developer 2)**

| | |
|---|---|
| Surfactant-1 (SOFTAZOLINE LPB-R, produced by Kawaken Fine Chemicals Co., Ltd.) | 150 parts by weight |
| Surfactant-2 (SOFTAZOLINE LAO, produced by Kawaken Fine Chemicals Co., Ltd.) | 40 parts by weight |
| Chelating agent: Trisodium ethylenediaminesuccinate (OCTAQUEST E30, produced by Innospec Specialty Chemicals Inc.) | 6.8 parts by weight |
| 2-Bromo-2-nitxopropane-1,3-diol | 0.25 parts by weight |
| 2-Methyl-4-isothiazoline-3-one | 0.25 parts by weight |
| Silicone type deforming agent: (TSA 739, produced by GE Toshiba Silicone Co., Ltd.) | 1.5 parts by weight |
| Sodium gluconate | 15 parts by weight |
| Sodium carbonate | 10.6 parts by weight |
| Sodium hydrogen carbonate | 5.2 parts by weight |
| Water | 770.4 parts by weight |

The pH was adjusted to 9.8 with sodium hydroxide and hydrochloric acid.

**(Developer 3)**

| | |
|---|---|
| Water | 88.6 parts by weight |
| Nonionic Surfactant (W-1) shown below | 2.4 parts by weight |
| Nonionic Surfactant (W-2) shown below | 2.4 parts by weight |
| Nonionic Surfactant (EMALEX 710, produced by Nihon Emulsion Co., Ltd.) | 1.0 parts by weight |
| Phenoxypropanol | 1.0 parts by weight |
| Octanol | 0.6 parts by weight |
| N-(2-Hydroxyethyl)morpholine | 1.0 parts by weight |
| Triethanolamine | 0.5 parts by weight |
| Sodium gluconate | 1.0 parts by weight |
| Trisodium citrate | 0.5 parts by weight |
| Tetrasodium ethylenediaminetetraacetate | 0.05 parts by weight |
| Polystyrenesulfonic acid (VERSA TL77 (30% by weight solution), produced by Alco Chemical Inc.) | 1.0 parts by weight |

The pH was adjusted to 6.9 with phosphoric acid.

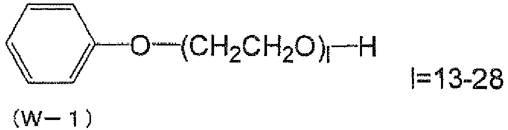

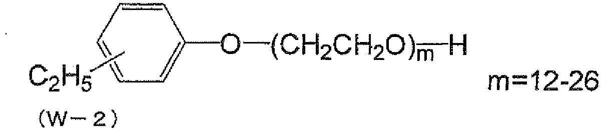

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

### <Evaluation>

Using each lithographic printing plate, the fingerprint trace stain preventing property, stain preventing property in the non-image area and printing durability were evaluated in the manner shown below.

### (Fingerprint trace stain preventing property)

A thumb was pressed on the non-image area of lithographic printing plate for 10 seconds and the lithographic printing plate was allowed to stand for one day under an environment of temperature of 25°C and relative humidity of 70% without protecting with an interleaf or the like. Thereafter, the lithographic printing plate was subjected to the printing under the condition described above and it was visually observed whether the portion pressed by the thumb formed printing stain or not. The fingerprint trace stain preventing property was evaluated according to the criteria described below.
A: Printing stain was not recognized at all.
B: Although a slight spot-like printing stain was recognized, it was at the acceptable level.
C: Printing stain due to fingerprint trace was clearly recognized.
A-B: Intermediate level between A and B.

### (Stain preventing property in non-image area)

The lithographic printing plate was subjected to the printing under the condition described above and after printing 10,000 sheets the stain on a blanket corresponding to the non-image area was visually observed according to the criteria described below.
A: Stain on the blanket was not recognized at all.
B: Stain on the blanket was hardly observed.
C: Stain on the blanket was considerably observed.

### (Printing durability)

The lithographic printing plate was subjected to the printing under the condition described above. As increase in the number of printed materials, the image area of the lithographic printing plate was gradually abraded to cause decrease in the ink receptive property, resulting in decrease of ink density of the image on the printed material. A number of printed materials obtained until the ink density (reflection density) decreased by 0.1 from that at the initiation of printing was determined to evaluate the printing durability.

The results of evaluation are shown in Tables 4 to 6.

**TABLE 4**

| | Surface Treated Support | Intermediate Layer | Photosensitize Layer | Protective Layer | Developer | Fingerprint Trace Stain Preventing Property | Stain Preventing Property in Non-Image Area | Printing Durability (x 10³ sheets) |
|---|---|---|---|---|---|---|---|---|
| Example 1 | 5 | | 7 | 1 | 1 | A | A | 66 |
| Example 2 | 6 | | 7 | 1 | 1 | A | A | 65 |
| Example 3 | 7 | | 7 | 1 | 1 | A | A | 60 |
| Example 4 | 8 | | 7 | 1 | 1 | A | A | 65 |
| Example 5 | 9 | | 7 | 1 | 1 | A | A | 63 |
| Example 6 | 10 | | 7 | 1 | 1 | A | A | 61 |
| Example 7 | 11 | | 7 | 1 | 1 | A | A | 65 |
| Example 8 | 12 | | 7 | 1 | 1 | A-B | A | 61 |
| Example 9 | 13 | | 7 | 1 | 1 | A-B | A | 69 |
| Example 10 | | 21 | 7 | 1 | 1 | A | A | 70 |
| Example 11 | | 22 | 7 | 1 | 1 | A | A | 85 |
| Example 12 | | 23 | 7 | 1 | 1 | A | A | 84 |
| Example 13 | | 24 | 7 | 1 | 1 | A | A | 60 |
| Example 14 | | 25 | 7 | 1 | 1 | A | A | 64 |
| Example 15 | | 26 | 7 | 1 | 1 | A | A | 62 |
| Example 16 | | 27 | 7 | 1 | 1 | A | A | 60 |
| Example 17 | | 28 | 7 | 1 | 1 | A-B | A | 64 |
| Example 18 | | 29 | 7 | 1 | 1 | B | A | 62 |
| Example 19 | | 31 | 7 | 1 | 1 | A | A | 78 |
| Example 20 | | 33 | 7 | 1 | 1 | A | A | 75 |
| Example 21 | | 34 | 7 | 1 | 1 | A | A | 60 |
| Example 22 | | 35 | 7 | 1 | 1 | A | A | 62 |
| Example 23 | | 36 | 7 | 1 | 1 | A | A | 60 |
| Example 24 | | 37 | 7 | 1 | 1 | A | A | 64 |
| Example 25 | | 38 | 7 | 1 | 1 | A-B | A | 62 |
| Example 26 | 7 | | 7 | 1 | 2 | A | A | 62 |
| Example 27 | 7 | | 7 | 2 | 1 | A | A | 60 |
| Example 28 | 7 | | 7 | 2 | 2 | A | A | 64 |
| Example 29 | 7 | | 7 | 2 | 3 | A | A | 62 |
| Example 30 | 7 | | 12 | 1 | 2 | A | A | 60 |
| Example 31 | 7 | | 12 | 2 | 1 | A | A | 64 |
| Example 32 | 7 | | 12 | 2 | 2 | A | A | 62 |
| Example 33 | 7 | | 12 | 2 | 3 | A | A | 60 |
| Example 34 | | 23 | 7 | 1 | 2 | A | A | 64 |
| Example 35 | | 23 | 7 | 2 | 1 | A | A | 62 |
| Example 36 | | 23 | 7 | 2 | 2 | A | A | 60 |
| Example 37 | | 23 | 7 | 2 | 3 | A | A | 64 |
| Example 38 | | 23 | 12 | 1 | 2 | A | A | 62 |
| Example 39 | | 23 | 12 | 2 | 1 | A | A | 60 |
| Example 40 | | 23 | 12 | 2 | 2 | A | A | 64 |
| Example 41 | | 23 | 12 | 2 | 3 | A | A | 62 |
| Example 42 | | 33 | 7 | 1 | 2 | A | A | 60 |
| Example 43 | | 33 | 7 | 2 | 1 | A | A | 64 |
| Example 44 | | 33 | 7 | 2 | 2 | A | A | 62 |
| Example 45 | | 33 | 7 | 2 | 3 | A | A | 62 |
| Example 46 | | 33 | 12 | 1 | 2 | A | A | 60 |
| Example 47 | | 33 | 12 | 2 | 1 | A | A | 64 |
| Example 48 | | 33 | 12 | 2 | 2 | A | A | 62 |
| Example 49 | | 33 | 12 | 2 | 3 | A | A | 62 |
| Comparative Example 1 | 14 | | 7 | 1 | 1 | C | A | 72 |
| Comparative Example 2 | 15 | | 7 | 1 | 1 | C | A | 65 |
| Comparative Example 3 | 16 | | 7 | 1 | 1 | C | A | 62 |
| Comparative Example 4 | 17 | | 7 | 1 | 1 | C | A | 68 |
| Comparative Example 5 | 18 | | 7 | 1 | 1 | C | A | 82 |
| Comparative Example 6 | 19 | | 7 | 1 | 1 | C | A | 60 |
| Comparative Example 7 | 20 | | 7 | 1 | 1 | B | A | 55 |
| Comparative Example 8 | | 30 | 7 | 1 | 2 | B | A | 65 |
| Comparative Example 9 | | 32 | 7 | 1 | 1 | C | A | 70 |
| Comparative Example 10 | | 39 | 7 | 1 | 1 | C | A | 62 |
| Comparative Example 11 | | 40 | 7 | 1 | 1 | C | B | 50 |
| Comparative Example 12 | | 41 | 7 | 1 | 1 | C | B | 67 |
| Comparative Example 13 | | 42 | 7 | 1 | 1 | B | A | 60 |

**TABLE 5**

| | Surface Treated Support | Intermediate Layer | Photosensitive Layer | Protective Layer | Developer | Fingerprint Trace Stain Preventing Property | Stain Preventing Property in Non-image Area | Printing Durability (x 10³ sheets) |
|---|---|---|---|---|---|---|---|---|
| Example 50 | 16 | | 1 | 1 | 1 | A | A | 65 |
| Example 51 | 16 | | 2 | 1 | 1 | A | A | 62 |
| Example 52 | 16 | | 3 | 1 | 1 | A | A | 68 |
| Example 53 | 16 | | 4 | 1 | 1 | A | A | 65 |
| Example 54 | 16 | | 5 | 1 | 1 | A-8 | A | 70 |
| Example 55 | 16 | | 6 | 1 | 1 | A-B | A | 62 |
| Example 56 | 16 | | 8 | 1 | 1 | A | A | 64 |
| Example 57 | 16 | | 9 | 1 | 1 | A | A | 62 |
| Example 58 | 16 | | 10 | 1 | 1 | A | A | 64 |
| Example 59 | 16 | | 11 | 1 | 1 | A | A | 64 |
| Example 60 | | 39 | 1 | 1 | 1 | A | A | 60 |
| Example 61 | | 39 | 2 | 1 | 1 | A | A | 64 |
| Example 62 | | 39 | 3 | 1 | 1 | A | A | 64 |
| Example 63 | | 39 | 4 | 1 | 1 | A | A | 62 |
| Example 64 | | 39 | 5 | 1 | 1 | A-B | A | 68 |
| Example 65 | | 39 | 6 | 1 | 1 | B | A | 62 |
| Example 66 | | 39 | 8 | 1 | 1 | A | A | 60 |
| Example 67 | | 39 | 9 | 1 | 1 | A | A | 61 |
| Example 68 | | 39 | 10 | 1 | 1 | A | A | 63 |
| Example 69 | | 39 | 11 | 1 | 1 | A | A | 60 |
| Example 70 | 16 | | 1 | 1 | 2 | A | A | 64 |
| Example 71 | 16 | | 1 | 2 | 1 | A | A | 63 |
| Example 72 | 16 | | 1 | 2 | 2 | A | A | 64 |
| Example 73 | 16 | | 1 | 2 | 3 | A-B | A | 64 |
| Example 74 | | 39 | 1 | 1 | 2 | A | A | 82 |
| Example 75 | 14 | | 1 | 1 | 1 | A | A | 72 |
| Example 76 | 15 | | 1 | 1 | 1 | A | A | 70 |
| Example 77 | 16 | | 1 | 1 | 1 | A | A | 64 |
| Example 78 | | 30 | 1 | 1 | 1 | A | A | 70 |
| Example 79 | | 32 | 1 | 1 | 1 | A | A | 64 |
| Example 80 | | 39 | 1 | 1 | 1 | A | A | 65 |
| Comparative Example 14 | | 39 | 7 | 1 | 1 | C | A | 62 |
| Comparative Example 15 | | 39 | 12 | 1 | 1 | C | A | 63 |
| Comparative Example 16 | | 39 | 13 | 1 | 1 | C | B | 50 |
| Comparative Example 17 | | 39 | 14 | 1 | 1 | C | B | 56 |
| Comparative Example 18 | | 39 | 15 | 1 | 1 | C | B | 41 |

**TABLE 6**

| | Surface Treated Support | Intermediate Layer | Photosensitive Layer | Protective Layer | Developer | Fingerprint Trace Stain Preventing Property | Stain Preventing Property in Non-Image Area | Printing Durability (x 10³ sheets) |
|---|---|---|---|---|---|---|---|---|
| Example 81 | 7 | | 1 | 1 | 1 | A | A | 66 |
| Example 82 | | 33 | 1 | 1 | 1 | A | A | 65 |
| Example 83 | 7 | | 8 | 1 | 1 | A | A | 60 |
| Example 84 | | 33 | 8 | 1 | 1 | A | A | 65 |
| Example 85 | 7 | | 8 | 1 | 2 | A | A | 63 |
| Example 86 | 7 | | 8 | 2 | 2 | A | A | 61 |
| Example 87 | 7 | | 8 | 2 | 3 | A | A | 65 |
| Example 88 | | 33 | 8 | 1 | 2 | A | A | 61 |
| Example 89 | | 33 | 8 | 2 | 2 | A | A | 69 |
| Example 90 | | 33 | 8 | 2 | 3 | A | A | 69 |
| Example 91 | | 35 | 8 | 1 | 1 | A | A | 69 |
| Comparative Example 19 | | 40 | 13 | 1 | 1 | C | B | 45 |

### Examples 92 to 95

### <Formation of Photosensitive layer 16>

Coating solution 3 for photosensitive layer having the composition shown below was coated so as to have a dry coating amount of 1.4 g/m² and dried at 100°C for one minute to form Photosensitive layer 16.

### <Coating solution 3 for photosensitive layer>

| | |
|---|---|
| Polymerizable compound (Compound A shown above) | 4.0 parts by weight |
| Binder polymer (Binder B shown below) (weight average molecular weight: 30,000) | 2.0 parts by weight |
| Sensitizing Dye (C-1) shown above | 0.32 parts by weight |
| Polymerization Initiator (D-1) shown above | 0.61 parts by weight |
| Sodium gluconate | 0.10 parts by weight |
| Chain Transfer Agent (E-1) shown above | 0.57 parts by weight |
| N-Nitrosophenylhydroxylamine aluminum salt | 0.020 part by weight |
| Dispersion of ε-phthalocyanine | 0.71 parts by weight |
| (pigment: 15% by weight; dispersing agent (Polymer (1) shown above (weight average molecular weight: 60,000)): 10% by weight; solvent (cyclohexanone/methoxypropyl acetate/1-methoxy-2-propanol = 15% by weight/20% by weight/40% by weight)) | |
| Fluorine-based nonionic surfactant (MEGAFAC F780, produced by Dainippon Ink & Chemicals, Inc.)) | 0.016 part by weight |
| Methyl ethyl ketone | 47 parts by weight |
| Propylene glycol monomethyl ether | 45 parts by |
| | weight |

### Binder B:

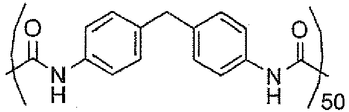

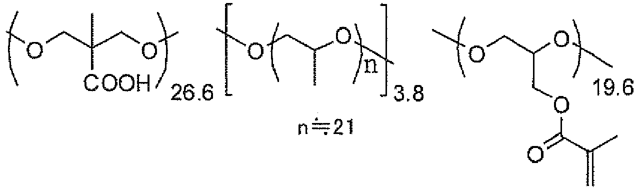

### <Composition of Developer>

**(Developer 4)**

| | |
|---|---|
| NEWCOL B-13 (produced by Nippon Nyukazai Co., Ltd.) | 3 g |
| Chelating agent: Trisodium ethylenediaminesuccinate (OCTAQUEST E30, produced by Innospec Specialty Chemicals Inc.) | 0.68 g |
| 2-Bromo-2-nitropropane-1,3-diol | 0.025 g |
| 2-Methyl-4-isothiazoline-3 -one | 0.025 g |
| Silicone type deforming agent: (TSA 739, produced by GE Toshiba Silicone Co., Ltd.) | 0.15 g |
| Sodium gluconate | 1.5 g |
| Sodium carbonate | 1.06 g |
| Sodium hydrogen carbonate | 0.52 g |
| Water | 77.04 g |
| (pH: 9.8) | |

### (Developer 5)

Developer 5 was prepared by adding the material shown below to Developer 4.

| | |
|---|---|
| Enzyme (NS44126, produced by Novozymes Japan Ltd., 7.5% aqueous solution) | 0.3 g |
| (pH: 9.8) | |

**(Developer 6)**

| | |
|---|---|
| Propylene oxide-ethylene oxide block copolymer (PE 9400, produced by BASF AG) | 20.0 g |
| Surfactant (EMULSOGEN TS 160, produced by Clariant AG) | 0.30 g |
| Sodium gluconate | 0.75 g |
| 85% Aqueous phosphoric acid solution | 5.88 g |
| Triethanolamine | 14.5 g |
| Water | 73.07 g |
| (pH: 7.0) | |

### (Developer 7)

Developer 7 was prepared by adding the material shown below to Developer 6.

| | |
|---|---|
| Enzyme (NS44126, produced by Novozymes Japan Ltd., 7.5% aqueous solution) | 0.3 g |
| (pH: 7.0) | |

The surface treated support, intermediate layer, photosensitive layers and protective layers were combined as shown in Table 7 below to prepare lithographic printing plate precursors. The lithographic printing plate precursors were subjected to the exposure, development, printing and evaluation in the same manner as in Example 1 using the developers as shown in Table 7, respectively. The results obtained are shown in Table 7.

**TABLE 7**

| | Surface Treated Support | Intermediate Layer | Photosensitive Layer | Protective Layer | Developer | Fingerprint Trace Stain Preventing Property | Stain Preventing Property in Non-Image Area | Printing Durability (x 10³ sheets) |
|---|---|---|---|---|---|---|---|---|
| Example 92 | | 22 | 16 | 1 | 4 | A | B | 105 |
| Example 93 | | 22 | 16 | 1 | 5 | A | A | 103 |
| Example 94 | 8 | | 7 | 2 | 6 | A | A | 64 |
| Example 95 | 8 | | 7 | 2 | 7 | A | A | 64 |

As is apparent from the results shown in Tables 4 to 7, the lithographic printing plate excellent in the fingerprint trace stain preventing property without accompanying degradations of the stain preventing property in non-image area and printing durability can be obtained by incorporating the hydroxycarboxylate salt into the intermediate layer adjacent to the support.

Further, lithographic printing plates were prepared in the same manner as described above except that the plate surface exposure amount at the image exposure was changed to 0.40 mJ/cm² and the heater in the pre-heating unit was turned off (specifically, the pre-heating was not conducted) and evaluated in the same manner as described above. The good results similar to those described above were obtained with the lithographic printing plates.

## Claims

1. A method for preparing a lithographic printing plate comprising the steps of imagewise exposing and then developing, without a water washing step, a lithographic printing plate precursor with a developer having a pH of from 6.9 to 10.3 and which comprises a surfactant and/or a water-soluble polymer compound, and (i) a carbonate ion and a hydrogen carbonate ion, or (ii) a water-soluble amine compound and an ion of the amine compound;
the lithographic printing plate precursor comprising
a support;
an image-recording layer comprising (A) a sensitizing dye having an absorption maximum in the wavelength range 300 to 450 nm, (B) a hexaarylbiimidazole compound as a polymerization initiator, (C) a polymerizable compound and (D) a binder polymer; and
an intermediate layer comprising a hydroxycarboxylate salt between the support and the image-recording layer.

2. A method according to Claim 1, wherein the hydroxycarboxylate salt has a molecular weight of 600 or less.

3. A method according to Claim 1 or Claim 2, wherein the total number of hydroxy groups and carboxylic acid groups included in the hydroxycarboxylate salt is 3 or more.

## Patentansprüche

1. Verfahren zur Herstellung einer Lithographiedruckplatte, umfassend die Schritte der bildweisen Belichtung und dann des Entwickelns, ohne einen Wasserwaschschritt, eines Lithographiedruckplattenvorläufers mit einem Entwickler, der einen pH-Wert von 6,9 bis 10,3 aufweist und der ein Tensid und/oder eine wasserlösliche Polymerverbindung, und (i) ein Carbonat-Ion und ein Hydrogencarbonat-Ion oder (ii) eine wasserlösliche Aminverbindung und ein Ion der Aminverbindung umfasst;
wobei der Lithographiedruckplattenvorläufer umfasst:
einen Träger;
eine Bildaufzeichnungsschicht, umfassend (A) einen Sensibilisierungsfarbstoff mit einem Absorptionsmaximum im Wellenlängenbereich von 300 bis 450 nm, (B) eine Hexaarylbiimidazolverbindung als einem Polymeriationsinitiator, (C) eine polymerisierbare Verbindung und (D) ein Bindepolymer; und
eine Zwischenschicht, die ein Hydroxycarboxylatsalz umfasst, zwischen dem Träger und der Bildaufzeichnungsschicht.

2. Verfahren gemäß Anspruch 1, worin das Hydroxycarboxylatsalz ein Molekulargewicht von 600 oder kleiner aufweist.

3. Verfahren gemäß Anspruch 1 oder Anspruch 2, worin die Gesamtanzahl der Hydroxygruppen und der Carbonsäuregruppen, die in dem Hydroxycarboxylatsalz enthalten sind, 3 oder größer ist.

## Revendications

1. Procédé de préparation d'une plaque d'impression lithographique comprenant les étapes d'exposition puis de développement conformément à une image, sans étape de lavage à l'eau, d'un précurseur de plaque d'impression lithographique avec un révélateur ayant un pH de 6,9 à 10,3 et qui comprend un surfactant et/ou un composé polymère soluble dans l'eau, et (i) un ion carbonate et un ion hydrogénocarbonate, ou (ii) un composé d'amine soluble dans l'eau et un ion du composé d'amine;
le précurseur de plaque d'impression lithographique comprenant :
un support ;
une couche d'enregistrement d'image comprenant (A) un colorant sensibilisant ayant un maximum d'absorption dans la plage de longueurs d'onde 300 à 450 nm, (B) un composé d'hexaarylbiimidazole en tant qu'initiateur de polymérisation, (C) un composé polymérisable et (D) un polymère de liaison; et
une couche intermédiaire comprenant un sel d'hydroxycarboxylate entre le support et la couche d'enregistrement d'image.

2. Procédé selon la revendication 1, dans lequel le sel d'hydroxycarboxylate a un poids moléculaire de 600 ou moins.

3. Procédé selon la revendication 1 ou la revendication 2, dans lequel le nombre total de groupes hydroxy et de groupes acide carboxylique dans le sel d'hydroxycarboxylate est 3 ou plus.
